Europäisches Patentamt

European Patent Office

Office européen des brevets

(11) Publication number: 0 296 639 B1

# EUROPEAN PATENT SPECIFICATION

(45) Date of publication of patent specification: 22.04.92

(51) Int. Cl.5: C04B 35/00, H01L 39/24, B01J 3/08

(21) Application number: 88110229.7

(22) Date of filing: 27.06.88

(54) Process for fabricating superconducting ceramic materials.

(30) Priority: 25.06.87 JP 156623/87
21.08.87 JP 207693/87
26.08.87 JP 212251/87
26.08.87 JP 212253/87
28.08.87 JP 212961/87
28.08.87 JP 212963/87
28.08.87 JP 212965/87
28.08.87 JP 212971/87

(43) Date of publication of application:
28.12.88 Bulletin 88/52

(45) Publication of the grant of the patent:
22.04.92 Bulletin 92/17

(84) Designated Contracting States:
DE FR GB NL SE

(56) References cited:
EP-A- 0 207 371

JAPANESE JOURNAL OF APPLIED PHYSICS, vol. 26, no. 5, May 1987, pages L834-L835; Y. SAITO et al.: "Composition dependence of superconductivity in (Ba0.1La1.9)AgxCu1-xO4-y system"

(73) Proprietor: MITSUBISHI MATERIALS CORPORATION
6-1, Otemachi 1-chome
Chiyoda-ku Tokyo(JP)

(72) Inventor: Takeshita, Takuo
149-404, Kishiki-cho 3-chome
Omiya-shi Saitama-ken(JP)
Inventor: Nakayama, Ryoji
2-58-7-102, Toro-cho
Omiya-shi Saitama-ken(JP)
Inventor: Hagino, Sadaaki
7-203, 2-33-8, Harayama
Urawa-shi Saitama-ken(JP)
Inventor: Suzuki, Motokazu
1135-4, Shima-cho
Omiya-shi Saitama-ken(JP)

(74) Representative: Haug, Dietmar et al
Patentanwälte Andrae, Flach, Haug, Kneissl
Balanstrasse 55
W-8000 München 90(DE)

**EXTENDED ABSTRACTS; HIGH TEMPERA-
TURE SUPERCONDUCTORS, PROCEEDINGS
OF SYMPOSIUM S, 1987 SPRING MEETING OF
THE MATERIALS RESEARCH SOCIETY, Ana-
heim, California, 23rd-24th April 1987, pages
219-221; S. JIN et al.: "Fabrication of 91K
superconducting coils"**

**Description**

BACKGROUND OF THE INVENTION

The present invention relates to a process for fabricating superconducting ceramics materials comprising a yttrium-including rare earth element, an alkaline earth metal and copper oxide (herinafter referred to as "R-A-Cu-O based ceramics") which has a high theoretical density ratio and thus has a high critical current value.

Conventional processes for fabricating worked materials such as wire rods, plates, strings, coils and ribbons made of an R-A-Cu-O based superconducting ceramics include a process in which starting powders, i.e., an $R_2O_3$ powder, an alkaline earth metal carbonate powder, and a CuO powder, each having an average grain size of not greater than 10 um, are provided and compounded in a predetermined compounding ratio followed by mixing and compacting them to obtain a compacted body, which is then calcined, e.g., in an atmos-phere of dry air, at a temperature of from 850 °C to 950 °C to form a superconducting ceramics having a composition of $YBa_2Cu_3O_7$, for example, the ceramics is then ground to obtain powder of an average grain size of not greater than 10 um and filled in a pipe of silver (Ag) or copper (Cu), and the pipe filled with the ceramics powder is molded into a worked material of a predetermined shape by cold processing such as swaging, rolling with grooved rolls, and processing with a die.

With the above-described conventional processes, it is very difficult to fill superconducting ceramics powder in a metal pipe in a filling ratio of not lower than 50% when fabricating processed superconducting materials or members. Further, it is noted that worked materials fabricated using such compacted body of a low filling ratio when cold processed have a theoretical density ratio of at most about 90%. In addition, it is also difficult upon calcination to fabricate superconducting ceramics with an oxygen content as high as up to 100% of theoretical content, and the resulting sueprconducting ceramics tends to lack oxygen. For example, when fabrication of $YBa_2Cu_3O_7$ is contemplated, product has a composition of $YBa_2Cu_3O_{7-d}$. Under the circumstances, high critical current value and high critical temperature of superconducting ceramics worked materials cannot be secured with the conventional processes.

SUMMARY OF THE INVENTION

An object of the present invention to obviate defects of the conventional processes and provide a process for fabricating processed superconducting ceramics materials having a high theoretical density ratio.

Another object of the present invention is to provide a process for fabricating processed superconducting ceramics materials which permits supply of oxygen with ease.

Still another object of the present invention is to provide a process for fabricating processed superconducting ceramics materials having a high critical current value and a high critical temperature.

Yet another object of the present invention is to provide a process for fabricating processed superconducting ceramics materials with improved crystalline orientation.

As a result of extensive investigation, it has now been found that application of explosive force to starting powder for fabricating processed R-A-Cu-O-based superconducting ceramics materials gives rise to compacted body having a theoretical density ratio much higher than that of the processed superconducting ceramics materials fabricated in the conventional manner, and thus final processed ceramics materials fabricated exhibit high critical current value and high critical temperature.

Therefore, the present invention provides a process for fabricating superconducting ceramics material composed essentially of a yttrium-including rare earth element, an alkaline earth metal, copper and balance oxygen and unavoidable impurities, and optionally containing a metal originating from an oxygen supplying agent, comprising:

(a) providing starting powder composed of:
(i) a member selected from the group consisting of:
(1) a mixed powder composed of powders of:
(1-1) a yttrium-including rare earth element oxide,
(1-2) an alkaline earth metal oxide, and
(1-3) copper oxide,
the mixture having a composition substantially the same as that of a contemplated superconducting ceramics,
(2) a mixed powder composed of powders of:
(2-1) a partial compound between any two of the com ponent oxides constituting a contemplated superconductive ceramic selected from (1-1), (1-2) and (1-3), and

(2-2) the rest of the component oxides selected from (1-1), (1-2) and (1-3),

the mixture having a composition substantially the same as that of a contemplated superconducting ceramics,

(3) powder of a superconducting ceramics composed essentially of a yttrium-including rare earth element, an alkaline earth metal, copper and balance oxygen and unavoidable impurities,

(4) a mixed powder composed of at least two members selected from the mixt powders (1), (2) and (4); and

(ii) optionally an oxygen-supply agent;

(b) placing said starting powder in a metal casing and sealing said metal casing;

(c) applying explosion force to said starting powder from outside of said metal casing to render said starting powder shock-compressed;

(d) optionally heat-treating said starting powder when said starting powder is the mixed powder (1-1), (1-2) or (1-4) at a temperature sufficient for calcining said starting powder prior to or after said application of explosion force;

(e)processing said explosively compressed product to produce an article having a predetermined form; and

(f) optionally heat-treating said article at a temperature of from 300 °C to 950 °C.

## DETAILED DESCRIPTION OF THE INVENTION

Hereinafter, description will at first be made on a typical embodiment of the present invention, in which the starting material for fabricating processed superconductung ceramics material is powder of a superconducting ceramics (R-A-Cu-O) composed essentially of a yttrium-including rare earth element (R), and alkaline earth metal (A), copper (Cu), and balance oxygen (O) and unavoidable impurities.

Suitable examples of the yttrium-including rare earth element which can be used include yttrium (Y), erbium (Er), dysprosium (Dy), ytterbium (Yb), gadolinium (Gd), thulium (Tm), neodymium (Nd), (Lu), and samarium (Sm). Of these, yttrium is preferred. The yttrium-including rare earth elements can be used singly or in combination.

Suitable examples of the alkaline earth metal which can be used in the present invention include barium, strontium and calcium, with barium being preferred. The alkaline earth metal can be used singly or in combination.

Powder of superconducting ceramics which can be used as a starting powder in the process of the present invention can be prepared, e.g., by calcining a mixture of single component oxides with a composition substantially the same as that of a contemplated ceramics material or article in an oven at a temperature suitable for preparing ceramics, e.g., 300 to 950 °C, and grinding the resulting superconducting ceramics material to have a desired mean grain size, e.g., not greater than 10 um. Generally, smaller mean grain size, e.g., not greater than 5 um, is preferred. Of course, it is possible to use superconducting ceramics material otherwise prepared as far as it has a composition of R-A-Cu-O, e.g., $YBa_2Cu_3O_7$, to be fabricated after grinding, if desired.

The starting powder is filled and sealed in a metal casing or sheath. Preferably, the metal sheath which can preferably permeate oxygen. Suitable examples of the metal which can be used include copper, aluminium, and silver, and alloys thereof.

The shape of the casing is not limited and can be of any desired form depending on the shape of articles to be contemplated as far as it is suited for holding and sealing therein starting powder.

After filling the starting powder in the metal casing, the casing is sealed. Sealing can be performed in the air or in vacuo. The metal casing containing the starting powder is then subjected to shock compression by application of explosion force.

After the shock compression, the resulting superconducting ceramics material is then cold- or hot-processed, e.g., by swaging, processing with grooved rolls, processing with a die, or a like, to produce articles having a desired shape, e.g., wire rods, plates, ribbons, strings, and the like. Also, the superconducting ceramics article surrounded by the metal casing can be processed so that at least one portion of the ceramics has an open surface; in other words, a part of or the whole metal sheath can be removed from the superconducting ceramics material. During the above-described processing, annealing may be performed, if desired.

When superconducting ceramics wire rods and similar articles are to be fabricated, it is practically useful to process the wire rods such that the reduction of area of the wire rod is not less than 60% of the original one in order to increase critical current and critical temperature of the superconducting ceramics article.

Then, the processed materials can be heat-treated generally at a temperature of 300 °C to 950 °C, preferably from 850°C to 950 °C, and more preferably from 900 °C to 940 °C in order to relieve or relax stress generated during processing, and/or the heat-treatment serves to increase the oxygen content of the superconducting ceramics material.

It is very often the case that oxygen in the resulting ceramics is deficient, with the result that characteristics such as critical current and critical temperature of the superconductive ceramics material obtained are unsatisfactory. It is advantageous to add powder of an oxygen-supply agent composed of a metal oxide to the starting powder prior to being filled in the metal casing in order to supplement oxygen, which tends to be deficient in superconducting ceramics material, during the shock compression and/or heat-treatment after processing.

Examples of the metal oxide which can be used for this purpose include $Ag_2O$, $MnO_2$, $MoO_3$, $WO_3$, $V_2O_5$ and $Ti_3O_5$. The amount of the oxygen-supply agent to be added is preferably 1 to 5 % by weight based on the total powder composition. When the starting powder composition containing powder of the metal oxide as an oxygen-supply agent, filled in the metal casing, is shock-compressed or heated the metal oxide releases oxygen to compensate the ceramics composition for the deficiency of oxygen to increase the theoretical oxygen content ratio of the ceramics.

Alternatively, an oxide layer can be provided on the inner surface of the metal sheath as by oxidizing the inner surface of the sheath by heating it in the air prior to introducing therein the starting powder.

It is sometimes useful to add the oxygen-supply agent in the starting superconducting ceramics powder and at the same time provide an oxide layer on the inner surface of the metal sheath.

In another typical embodiment of the present invention, processed superconducting ceramics materials or superconducting ceramics articles can generally be fabricated starting from a mixture of powder of a yttrium-including rare earth element oxide ($R_2O_3$), powder of an alkaline earth metal oxide (AO) and powder of copper oxide (CuO). The composition of these single component oxides are blended so that the resulting mixture has a composition substantially the same as that of a final superconducting ceramics article.

Examples of the yttrium-including rare earth element oxide which can be used include oxides of yttrium-including rare earth element. The same yttrium-including rare earth elements describe above with respect to the preceding embodiment can be used in the instant embodiment. Of the oxides, yttrium oxide is preferred. The yttrium-including rare earth elements can be used singly or in combination.

Examples of the alkaline earth metal oxide which can be used in the present invention include oxides of barium, strontium and calcium. Barium oxide is preferred. The alkaline earth metal oxide can be used singly or in combination.

The single component oxides, i.e., powder of a rare earth element oxide, powder of an alkaline earth metal oxide and powder of copper oxide, each are commercially available. They can be used as they are or after being ground in order to adjust the mean grain size to a desired size. Usually, single component oxide powders to be used have a mean grain size of not greater than 10 um. Generally, smaller mean grain size, e.g., not greater than 5 um, is preferred.

The single component powders are well mixed with each other in a predetermined ratio appropriate for fabricating a contemplated superconducting ceramics material and the mixed powder composition as a starting material is filled and sealed in a metal casing or sheath. The same metal casing described above with respect to the embodiment in which powder of superconducting ceramics powder is used as a starting powder.

After filling the mixed powder composition in the metal casing, the casing is sealed. Sealing can be performed in the air or in vacuo. The metal casing containing the starting powders is then subjected to calcination and shock compression by application of explosion force. The calcination and shock compression operations may be conducted in this order or in reverse order.

The calcination of the mixed powder composition, which may be prior to or after being subjected to shock compression, can be performed at a predetermined temperature, preferably ranging from 850 °C to 950 °C, more preferably from 900 °C to 940 °C, in the air for a period sufficient to convert the mixed powder composition into a superconductive ceramics.

The mixed powder composition can be shock-compressed prior to or after being subjected to calcination under the conditions described above. The explosion force is applied to the mixed powder composition prior to or after conversion of the composition into ceramics from outside the metal casing in the same manner as described above with respect to the embodiment starting from the superconducting ceramics powder.

After the calcination and shock compression in this order or in reverse order, the resulting superconducting ceramics is then cold- or hot-processed, which can be performed in the same manner as in the case of the shock-compressed superconducting ceramics material starting from the superconducting ceramics powder.

The processed materials can be heat-treated in the same manner as in the case of one fabricated starting from the superconducting ceramics powder.

Further, it is advantageous to add an oxygen-supply agent to the starting single component oxide powders and/or to provide an oxide layer on the inner surface of the metal casing in the same manner as the superconducting ceramics article fabricated starting from the superconducting ceramics powder. The same kind and amount of the oxygen-supply agent as described above can be used. When the mixed powder composition containing powder of the metal oxide as an oxygen-supply agent, filled in the metal casing, is calcined the metal oxide powder releases oxygen to compensate the ceramics composition for the deficiency of oxygen to increase the theoretical oxygen content ratio of the ceramics. Substantially no difference is observed whether the mixed powder composition containing an oxygen-supply agent is at first subjected to calcination or to shock compression.

Further, according to a variation of the above-described embodiments, powder of partial compounds between any two of the component oxides for fabricating superconducting ceramics articles, i.e., a compound between the yttrium-including rare earth element and the alkaline earth metal oxide, a compound between the alkaline earth metal and copper oxide, and a compound between copper oxide and the yttrium-including rare earth element, can be used together with powder of the remainder of the component oxides, i.e., copper oxide, the yttrium-including rare earth element, and the alkaline earth metal, respectively, instead of using a mixture of powders of single component oxides only as a starting powder. For example, Y-Ba-CuO based superconducting ceramics articles can be fabricated using $Y_2O_3 \cdot BaO$ and $CuO$ in a composition substantially the same as that of the final ceramics. Other combinations such as $CuO \cdot BaO$, and $Y_2O_3 \cdot CuO$, together with $Y_2O_3$, and $BaO$, respectively, can also be used. Similarly, partial compounds can be used for ceramics compositions containing other yttrium-including rare earth elements.

The partial compounds between any two of the single components oxides for fabricating superconducting ceramics material can be commercially available or can be prepared in conventional manner, e.g., by calcining a mixture of powders of any two of the single component oxides described above in an oven at temperatures suitable for preparation of ceramics.

The ratio of powder of the partial compound to the remainder single component oxide which can be added is not critical as far as the resulting mixture has a composition substantially the same as that of a finally obtained superconducting ceramics article.

According to another variation, the mixed powder of the single component oxides, and/or the mixed powder of the partial compound and the remainder of the single component oxides, can be added to powder of the superconducting ceramics powder. In this case, the mixing ratio therebetween is not critical.

In the above-described variations, a processed superconducting ceramics can be obtained with substantially the same operations including calcination, shock compression and processing under substantially the same conditions as in the case of superconducting ceramics article obtained starting from a mixture of powders of single component oxides, and detailed explanation is omitted here.

EXAMPLES

The present invention will be explained in greater detail with reference to the following examples, which should in no way be construed as limiting the present invention.

Example 1

Various starting powders composed of R-A-Cu-O based superconducting ceramics powders having mean grain size and compositions as shown in Table 1 below were filled into a cylindrical casing made of Ag having a size of 10 mm in inner diameter, 1 mm thick and 100 mm long at a filling ratio of 60%, and thus-filled casing was placed upright in the center of a cardboard container having an inner diameter of 500 mm and a height of 200 mm together with 50 g of an explosive. Then, the explosive was fired to apply explosion force to the casing to give rise to shock-compressed body having a theoretical density ratio shown in Table 1 below. The shock-compressed body was cold processed by subjecting it to swaging and grooved roll-processing, each in a plurality of times, followed by drawing the product into wire rod at an area reduction shown in Table 1 below, and then heat-treating for oxidation under the conditions shown in Table 1, thus producing superconducting ceramics wire rods.

For comparison, the same procedures as above were repeated except that application of explosion force and heat treatment for oxidation were omitted to obtain comparative wire rods.

The theoretical density ratio, critical temperature (Tc) and critical current (Jc) of the superconducting ceramics wire rods thus obtained were determined and the results obtained are shown in Table 1.

From the results shown in Table 1 below, it can be seen that the superconducting ceramics wire rods fabricated according to the process of the present invention had a theoretical density ratio as high as near 100%. Observation with metallurgical microscope showed that the wire rods obtained had a mmetallographical structure of which C axis of crystal orientated in a direction vertical to the direction along which processing was carried out. These results correspond to high critical current and high critical temperature.

Table 1a

| | | Starting Powder | | | Mean Grain Size (um) |
|---|---|---|---|---|---|
| Run No. | R | Composition (wt.%) A | Cu | O | |
| 1-1 | Y: 13.3 | Ba: 41.2 | 28.6 | rem. | 0.9 |
| 1-2 | Er: 22.5 | Ba: 36.9 | 25.6 | rem. | 4.8 |
| 1-3 | Dy: 22.0 | Ba: 37.1 | 25.8 | rem. | 4.3 |
| 1-4 | Yb: 23.1 | Ba: 36.6 | 25.4 | rem. | 3.5 |
| 1-5 | Cd: 21.4 | Ba: 37.4 | 26.0 | rem. | 3.3 |
| 1-6 | Tm: 22.6 | Ba: 36.8 | 25.5 | rem. | 3.8 |
| 1-7 | Tb: 21.6 | Ba: 37.3 | 25.9 | rem. | 4.2 |
| 1-8 | Lu: 23.3 | Ba: 36.5 | 25.3 | rem. | 3.9 |
| 1-9 | Sm: 20.7 | Ba: 37.7 | 26.2 | rem. | 4.2 |
| 1-10 | Y: 13.5 | Ba: 37.7 Sr: 2.7 | 29.0 | rem. | 3.2 |
| 1-11 | Lu: 23.5 | Ba: 35.14 Ca: 0.54 | 25.7 | rem. | 2.8 |
| 1-12 | | Same as 1-1 above | | | |
| 1-13 | | Same as 1-2 above | | | |
| 1-14 | | Same as 1-3 above | | | |
| 1-15 | | Same as 1-4 above | | | |
| 1-16 | | Same as 1-5 above | | | |
| 1-17 | | Same as 1-6 above | | | |
| 1-18 | | Same as 1-7 above | | | |
| 1-19 | | Same as 1-8 above | | | |
| 1-20 | | Same as 1-9 above | | | |
| 1-21 | | Same as 1-10 above | | | |
| 1-22 | | Same as 1-11 above | | | |

8

EP 0 296 639 B1

Table 1b

|  | | | | Oxidative Heat Treament | | |
|---|---|---|---|---|---|---|
| Run | Theo-retical Density Ratio (%) | Area Reduc-tion (%) | Diameter of Wire Rod (mm) | Partial Pressure of Oxygen (atm.) | Tempera-ture (oC) | Period (min.) |
| 1-1 | 98.6 | 98 | 10 | 2 | 850 | 10 |
| 1-2 | 98.2 | 67 | 4.0 | 2 | 750 | 15 |
| 1-3 | 99.0 | 67 | 4.0 | 2 | 600 | 20 |
| 1-4 | 98.2 | 98 | 1.0 | 2 | 650 | 23 |
| 1-5 | 98.1 | 98 | 1.0 | 2 | 800 | 12 |
| 1-6 | 99.2 | 82 | 2.5 | 2 | 850 | 10 |
| 1-7 | 98.3 | 75 | 3.5 | 2 | 650 | 23 |
| 1-8 | 99.2 | 98 | 1.0 | 2 | 750 | 15 |
| 1-9 | 98.5 | 82 | 3.1 | 2 | 680 | 21 |
| 1-10 | 98.6 | 98 | 1.0 | 2 | 800 | 12 |
| 1-11 | 99.8 | 92 | 2.0 | 2 | 600 | 25 |
| 1-12 | – | Same as 1-1 above | | – | – | – |
| 1-13 | – | Same as 1-2 above | | – | – | – |
| 1-14 | – | Same as 1-3 above | | – | – | – |
| 1-15 | – | Same as 1-4 above | | – | – | – |
| 1-16 | – | Same as 1-5 above | | – | – | – |
| 1-17 | – | Same as 1-6 above | | – | – | – |
| 1-18 | – | Same as 1-7 above | | – | – | – |
| 1-19 | – | Same as 1-8 above | | – | – | – |
| 1-20 | – | Same as 1-9 above | | – | – | – |
| 1-21 | – | Same as 1-10 above | | – | – | – |
| 1-22 | – | Same as 1-11 above | | – | – | – |

Table 1c

| Characteristics of Article | | | |
|---|---|---|---|
| Run | Theoretical Density Ratio (%) | Critical Temperature (Jc) (°K) | Critical Current (Jc) (A/cm$^2$) |
| 1-1 | 99.0 | 92 | 6200 |
| 1-2 | 99.1 | 89 | 2500 |
| 1-3 | 99.0 | 86 | 3400 |
| 1-4 | 99.2 | 88 | 4000 |
| 1-5 | 98.6 | 87 | 4000 |
| 1-6 | 99.3 | 88 | 3800 |
| 1-7 | 98.9 | 85 | 3200 |
| 1-8 | 99.3 | 91 | 4000 |
| 1-9 | 98.8 | 84 | 3200 |
| 1-10 | 99.0 | 92 | 4500 |
| 1-11 | 98.9 | 90 | 4000 |
| 1-12 | 85.0 | 70 | 10 |
| 1-13 | 84.1 | 65 | 5 |
| 1-14 | 85.0 | 55 | 3 |
| 1-15 | 83.9 | 50 | 3 |
| 1-16 | 85.1 | 40 | 3 |
| 1-17 | 84.0 | 52 | 3 |
| 1-18 | 83.1 | 55 | 4 |
| 1-19 | 85.0 | 60 | 10 |
| 1-20 | 86.0 | 35 | 2 |
| 1-21 | 87.1 | 80 | 15 |
| 1-22 | 85.0 | 60 | 2 |

Example 2

Various starting powders composed of R-A-Cu-O based superconducting ceramics powders having mean grain size and compositions as shown in Table 2a below were filled into a cylindrical casing made of Ag having a size of 10 mm in inner diameter, 1 mm thick and 100 mm long at a filling ratio of 50%, and the thus-filled casing was placed upright in the center of a cardboard container having an inner diameter of 500 mm and a height of 200 mm together with 50 g of an explosive. Then, the explosive was fired to apply explosion force to the casing to give rise to shock-compressed body having a theoretical density ratio shown in Table 2b below. The shock-compressed body was cold processed by subjecting it to swaging and grooved roll-processing, each in a plurality of times, followed by drawing the product into wire rod at an area reduction shown in Table 2b below to obtain wire rods. The wire rods were annealed at a predetermined temperature of from 300 °C to 500 °C to fabricate superconducting ceramics wire rods.

For comparison, the same procedures as above were repeated except that application of explosion force were omitted to obtain comparative wire rods.

The theoretical density ratio, critical temperature (Tc) and critical current (Jc) of the superconducting ceramics wire rods thus obtained were determined and the results obtained are shown in Table 2c.

From the results shown in Table 2 below, it can be seen that the superconducting ceramics wire rods fabricated according to the process of the present invention had a theoretical density ratio much higher than that of the comparative wire rods. These results correspond to high critical current.

## Table 2a

| Run No. | | | Starting Powder | | | | Mean Grain Size (um) |
|---------|---|---|---|---|---|---|---|
| | | | Composition (wt.%) | | | | |
| | R | | A | | Cu | Q | |
| 2-1 | Y: | 13.3 | Ba: | 41.2 | 28.6 | rem. | 0.9 |
| 2-2 | Er: | 22.5 | Ba: | 36.9 | 25.6 | rem. | 3.5 |
| 2-3 | Dy: | 22.0 | Ba: | 37.1 | 25.8 | rem. | 3.2 |
| 2-4 | Yb: | 23.1 | Ba: | 36.6 | 25.4 | rem. | 4.2 |
| 2-5 | Cd: | 21.4 | Ba: | 37.4 | 26.0 | rem. | 3.1 |
| 2-6 | Tm: | 22.6 | Ba: | 36.8 | 25.5 | rem. | 3.8 |
| 2-7 | Nd: | 20.0 | Ba: | 38.1 | 26.5 | rem. | 4.1 |
| 2-8 | Lu: | 23.3 | Ba: | 36.5 | 25.3 | rem. | 3.6 |
| 2-9 | Sm: | 20.7 | Ba: | 37.7 | 26.2 | rem. | 3.5 |
| 2-10 | Y: | 13.5 | Ba: 37.7<br>Sr: 2.7 | | 29.0 | rem. | 4.1 |
| 2-11 | Lu: | 23.5 | Ba: 35.1<br>Ca: 0.5 | | 25.7 | rem. | 3.2 |
| 2-12 | | | Same as 2-1 above | | | | |
| 2-13 | | | Same as 2-2 above | | | | |
| 2-14 | | | Same as 2-3 above | | | | |
| 2-15 | | | Same as 2-4 above | | | | |
| 2-16 | | | Same as 2-5 above | | | | |
| 2-17 | | | Same as 2-6 above | | | | |
| 2-18 | | | Same as 2-7 above | | | | |

11

| | | | |
|---|---|---|---|
| 2-19 | | Same as 2-8 above | |
| 2-20 | | Same as 2-9 above | |
| 2-21 | | Same as 2-10 above | |
| 2-22 | | Same as 2-11 above | |

### Table 2b

**Characteristics of Wire Rod**

| Run | Theoretical Density Ratio (%) | Area Reduction (%) | Diameter of Wire Rod (mm) | Theoretical Density Ratio of Wire Rod (%) | Critical Current (A/cm$^2$) |
|---|---|---|---|---|---|
| 2-1 | 97.8 | 98 | 1.2 | 98.0 | 4700 |
| 2-2 | 98.5 | 98 | 1.2 | 98.6 | 2600 |
| 2-3 | 99.1 | 90 | 2.7 | 99.1 | 3100 |
| 2-4 | 98.5 | 90 | 2.7 | 98.4 | 3000 |
| 2-5 | 97.6 | 80 | 3.8 | 97.9 | 3500 |
| 2-6 | 98.8 | 80 | 3.8 | 99.0 | 3000 |
| 2-7 | 98.2 | 98 | 1.2 | 98.5 | 3200 |
| 2-8 | 99.0 | 98 | 1.2 | 99.1 | 3000 |
| 2-9 | 97.9 | 90 | 2.7 | 97.6 | 2600 |
| 2-10 | 98.3 | 90 | 2.7 | 98.5 | 4100 |
| 2-11 | 99.2 | 98 | 1.2 | 99.0 | 4100 |
| 2-12 | - | Same as 2-1 above | | 86.0 | 150 |
| 2-13 | - | Same as 2-2 above | | 83.2 | 30 |
| 2-14 | - | Same as 2-3 above | | 81.3 | 20 |
| 2-15 | - | Same as 2-4 above | | 83.5 | 30 |
| 2-16 | - | Same as 2-5 above | | 84.2 | 20 |
| 2-17 | - | Same as 2-6 above | | 85.2 | 30 |

| | | | | |
|---|---|---|---|---|
| 2-18 | - | Same as 2-7 above | 84.0 | 30 |
| 2-19 | - | Same as 2-8 above | 84.2 | 70 |
| 2-20 | - | Same as 2-9 above | 85.5 | 20 |
| 2-21 | - | Same as 2-10 above | 86.0 | 130 |
| 2-22 | - | Same as 2-11 above | 85.5 | 30 |

Example 3

The same starting powders as used in Example 2 (Table 2a), which were renamed as 3-1 to 3-22 in this example, were each filled into a cylindrical casing made of Ag having a size of 10 mm in inner diameter, 1 mm thick and 100 mm long at a filling ratio of 50%, and the both ends of the casing were sealed in the air. The thus-filled casing was placed upright in the center of a cardboard container having an inner diameter of 500 mm and a height of 200 mm together with 100 to 500 g of an explosive. Then, the explosive was fired to apply explosion force to the casing to give rise to shock-compressed body having a theoretical density ratio shown in Table 3 below. The shock-compressed body was cold processed by subjecting it to swaging and grooved roll-processing, each in a plurality of times, followed by drawing the product into wire rod at an area reduction shown in Table 3 below to obtain wire rods. The wire rods were heat-treated at 930 °C for 8 to 6 hours to fabricate superconducting ceramics wire rods.

For comparison, the same procedures as above were repeated except that application of explosion force were omitted to obtain comparative wire rods.

The theoretical density ratio, critical temperature (Tc) and critical current (Jc) of the superconducting ceramics wire rods thus obtained were determined and the results obtained are shown in Table 3.

From the results shown in Table 3 below, it can be seen that the superconducting ceramics wire rods fabricated according to the process of the present invention had a theoretical density ratio much higher than that of the comparative wire rods. These results correspond to high critical current.

## Table 3

### Characteristics of Wire Rod

| Run | Theo-retical Density Ratio (%) | Area Reduc-tion (%) | Diameter of Wire Rod (mm) | Theoretical Density Ratio of Wire Rod (%) | Critical Current (A/cm$^2$) |
|---|---|---|---|---|---|
| 3-1 | 97.9 | 90 | 2.7 | 98.1 | 6900 |
| 3-2 | 98.3 | 85 | 3.3 | 98.3 | 2900 |
| 3-3 | 98.9 | 85 | 3.3 | 98.9 | 3300 |
| 3-4 | 98.3 | 85 | 3.3 | 98.5 | 3200 |
| 3-5 | 97.7 | 80 | 3.8 | 98.0 | 3400 |
| 3-6 | 98.7 | 90 | 2.7 | 98.9 | 2900 |
| 3-7 | 98.1 | 80 | 3.8 | 98.4 | 3900 |
| 3-8 | 98.8 | 80 | 3.8 | 98.9 | 3200 |
| 3-9 | 98.0 | 90 | 2.7 | 98.1 | 3300 |
| 3-10 | 98.1 | 85 | 3.3 | 98.3 | 3900 |
| 3-11 | 98.9 | 90 | 2.7 | 98.5 | 4400 |
| 3-12 | − | Same as 3-1 above | | 86.2 | 310 |
| 3-13 | − | Same as 3-2 above | | 84.3 | 70 |
| 3-14 | −· | Same as 3-3 above | | 82.9 | 30 |
| 3-15 | − | Same as 3-4 above | | 83.4 | 40 |
| 3-16 | − | Same as 3-5 above | | 83.1 | 70 |
| 3-17 | − | Same as 3-6 above | | 84.9 | 60 |
| 3-18 | − | Same as 3-7 above | | 83.1 | 50 |
| 3-19 | − | Same as 3-8 above | | 84.3 | 90 |
| 3-20 | − | Same as 3-9 above | | 84.6 | 30 |
| 3-21 | − | Same as 3-10 above | | 85.5 | 140 |
| 3-22 | − | Same as 3-11 above | | 86.1 | 60 |

14

Example 4

R-A-Cu-O based superconducting ceramics powder having mean grain size and compositions as shown in Table 4a below and a metal oxide powder as an oxygen-supply agent as shown in Table 4a below were blended at a blend ratio shown in Table 4a. After mixing, the resulting starting powder compositions were each filled into a cylindrical casing made of Cu having a size of 10 mm in inner diameter, 1 mm thick and 100 mm long at a filling ratio of 50%. After sealing it in vacuo, the thus-filled casing was placed upright in the center of a cardboard container having an inner diameter of 500 mm and a height of 200 mm together with 500 g of an explosive. Then, the explosive was fired to apply explosion force to the casing to give rise to shock-compressed body hving a theoretical density ratio shown in Table 4b below. The shock-compressed body was cold processed by subjecting it to swaging and grooved roll-processing, each in a plurality of times, followed by drawing the product into wire rod at an area reduction shown in Table 1 below. Then, the wire rod was heat-treated by holding it at a predetermined temperature of from 850 to 950 °C for a predetermined period of time in an inert atomosphere for supplying oxygen, thus producing superconducting ceramics wire rods.

For comparison, R-A-Cu-O based superconducting ceramics powder having a mean grain size and composition shown in Table 4a was filled in the same cylindrical Cu casing as described above at a filling ratio of 50%. After sealing it in vacuo, the casing was immediately cold processed under the same conditions as above to obtain wire rod, which was then heat-treated at a predetermined temperature of from 300 to 500 °C for 10 to 20 minutes to anneal it for stress relief, thus producing comparative wire rods.

The theoretical density ratio, critical temperature (Tc) and critical current (Jc) of the superconducting ceramics wire rods thus obtained were determined and the results obtained are shown in Table 4c.

From the results shown in Table 4c below, it can be seen that the superconducting ceramics wire rods fabricated according to the process of the present invention had a theoretical density ratio and a theoretical oxygen content ratio much higher than those of the comparative wire rods. These results correspond to high critical current and high critica temperature.

## Table 4a

| Run No. | Starting Powder Composition (wt.%) | | | | Mean Grain Size (um) | |
|---|---|---|---|---|---|---|
| | R | A | Cu | O | | |
| 4-1 | Y: 13.3 | Ba: 41.2 | 28.6 | rem. | 0.5 | 98.0 |
| 4-2 | Er: 22.5 | Ba: 36.9 | 25.6 | rem. | 0.7 | 97.0 |
| 4-3 | Dy: 22.0 | Ba: 37.1 | 25.8 | rem. | 1.0 | 98.8 |
| 4-4 | Yb: 23.1 | Ba: 36.6 | 25.4 | rem. | 1.2 | 97.5 |
| 4-5 | Gd: 21.4 | Ba: 37.4 | 26.0 | rem. | 2.0 | 99.0 |
| 4-6 | Tm: 22.6 | Ba: 36.8 | 25.5 | rem. | 0.6 | 98.8 |
| 4-7 | Nd: 20.0 | Ba: 38.1 | 26.5 | rem. | 2.5 | 97.0 |
| 4-8 | Lu: 23.3 | Ba: 36.5 | 25.3 | rem. | 3.0 | 98.8 |
| 4-9 | Sm: 20.7 | Ba: 37.7 | 26.2 | rem. | 3.1 | 99.0 |
| 4-10 | Y: 13.5 | Ba: 37.7 Sr: 2.7 | 29.0 | rem. | 0.8 | 98.5 |
| 4-11 | Lu: 23.5 | Ba: 35.1 Ca: 0.5 | 25.7 | rem. | 2.0 | 99.0 |
| 4-12 | Same as 4-1 above | | | | | 100 |
| 4-13 | Same as 4-2 above | | | | | 100 |
| 4-14 | Same as 4-3 above | | | | | 100 |
| 4-15 | Same as 4-4 above | | | | | 100 |
| 4-16 | Same as 4-5 above | | | | | 100 |
| 4-17 | Same as 4-6 above | | | | | 100 |
| 4-18 | Same as 4-7 above | | | | | 100 |
| 4-19 | Same as 4-8 above | | | | | 100 |
| 4-20 | Same as 4-9 above | | | | | 100 |
| 4-21 | Same as 4-10 above | | | | | 100 |
| 4-22 | Same as 4-11 above | | | | | 100 |

Table 4b

| Oxygen Supply Agent | | | |
|---|---|---|---|
| Run | Composition | Mean Grain Size (um) | Content (wt.%) |
| 4-1 | Ag2O | 5 | 2 |
| 4-2 | MnO2 | 6 | 3 |
| 4-3 | MoO3 | 4 | 1.2 |
| 4-4 | Ag2O | 5 | 2.0 |
|  | V203 | 8 | 0.5 |
| 4-5 | WO3 | 6 | 1.0 |
| 4-6 | V2O3 | 8 | 1.2 |
| 4-7 | Ag2O | 5 | 3 |
| 4-8 | V2O3 | 8 | 0.7 |
|  | Ti3O5 | 4 | 0.5 |
| 4-9 | Ti3O5 | 4 | 1.0 |
| 4-10 | MnO2 | 6 | 0.5 |
|  | WO3 | 7 | 1.0 |
| 4-11 | Ti3O5 | 1.0 | 1.0 |
| 4-12 | - | - | - |
| 4-13 | - | - | - |
| 4-14 | - | - | - |
| 4-15 | - | - | - |
| 4-16 | - | - | - |
| 4-17 | - | - | - |
| 4-18 | - | - | - |
| 4-19 | - | - | - |
| 4-20 | - | - | - |
| 4-21 | - | - | - |
| 4-22 | - | - | - |

## Table 4c

| | | | | Oxidative Heat Treatment | | | |
| Run | Theo-retical Density Ratio Aft. Exp. (%) | Area Reduction (%) | Diameter of Wire Rod (mm) | Theo-retical Density Ratio (%) | Theo-retical Oxygen Content Ratio (%) | Jc (A/cm$^2$) | Tc ($^{o}$K) |
|------|------|------|------|------|------|------|------|
| 4-1 | 98.0 | 98 | 1.2 | 98.5 | 99.9 | 4600 | 98 |
| 4-2 | 98.2 | 98 | 1.2 | 98.7 | 99.7 | 2900 | 97 |
| 4-3 | 98.1 | 98 | 1.2 | 99.0 | 99.8 | 3100 | 97 |
| 4-4 | 98.2 | 90 | 2.7 | 98.2 | 99.3 | 3050 | 93 |
| 4-5 | 97.8 | 95 | 1.9 | 98.3 | 99.7 | 3400 | 95 |
| 4-6 | 98.1 | 95 | 1.9 | 98.6 | 99.9 | 3050 | 99 |
| 4-7 | 97.9 | 95 | 1.9 | 99.1 | 99.6 | 3100 | 97 |
| 4-8 | 98.1 | 90 | 2.7 | 98.8 | 99.89 | 3200 | 97 |
| 4-9 | 97.5 | 90 | 2.7 | 99.9 | 99.7 | 2700 | 96 |
| 4-10 | 97.6 | 98 | 1.2 | 98.5 | 99.9 | 4100 | 100 |
| 4-11 | 97.8 | 98 | 1.2 | 98.8 | 99.3 | 4000 | 96 |
| 4-12 | – | Same as 4-1 above | | 89.2 | 98.1 | 200 | 82 |
| 4-13 | – | Same as 4-2 above | | 87.3 | 98.2 | 120 | 80 |
| 4-14 | – | Same as 4-3 above | | 86.1 | 98.6 | 25 | 77 |
| 4-15 | – | Same as 4-4 above | | 81.9 | 98.2 | 10 | 77 |
| 4-16 | – | Same as 4-5 above | | 83.7 | 98.9 | 35 | 78 |
| 4-17 | – | Same as 4-6 above | | 82.6 | 98.9 | 30 | 83 |
| 4-18 | – | Same as 4-7 above | | 83.4 | 98.9 | 50 | 84 |
| 4-19 | – | Same as 4-8 above | | 82.7 | 98.7 | 15 | 85 |
| 4-20 | – | Same as 4-9 above | | 86.4 | 98.8 | 160 | 83 |
| 4-21 | – | Same as 4-10 above | | 86.2 | 99.0 | 200 | 87 |
| 4-22 | – | Same as 4-11 above | | 87.5 | 98.9 | 180 | 82 |

Example 5

Various starting powders composed of R-A-Cu-O based superconducting ceramics powders having mean grain size and compositions as shown in Table 5a below were filled into a cylindrical casing made of

18

Cu have a size of 10 mm in inner diameter, 1 mm thick and 100 mm long and having formed on its inner surface an oxide layer of a thickness of 30 um by holding it in the air at a temperature of 450 °C for 10 hours at a filling ratio of 50%, and the thus-filled casing was placed upright in the center of a cardboard container having an inner diameter of 500 mm and a height of 200 mm together with 500 g of an explosive. Then, the explosive was fired to apply explosion force to the casing to give rise to shock-compressed body having a theoretical density ratio shown in Table 4b below. The shock-compressed body was cold processed by subjecting it to swaging and grooved roll-processing, each in a plurality of times, followed by drawing the product into wire rod at an area reduction shown in Table 5b below, and then heat-treating for oxidation at a predetermined temperature of from 300 to 500 °C for 20 to 60 minutes to effect oxygen supply from the inner oxide layer, thus producing superconducting ceramics wire rods.

For comparison, the same procedures as above were repeated except that application of explosion force and heat treatment for oxygen supply were omitted to obtain comparative superconducting ceramics wire rods.

The theorectical density ratio, critical temperature (Tc) and critical current (Jc) of the superconducting ceramics wire rods thus obtained were determined and the results obtained are shown in Table 5b.

From the results shown in Table 4b below, it can be seen that the superconducting ceramics wire rods fabricated according to the process of the present invention had a theoretical density ratio and a theoretical oxygen content ratio much higher than those of comparative superconducting ceramics wire rods. These results correspond to high critical current and high critical temperature.

## Table 5a

| Run No. | Starting Powder Composition (wt.%) | | | | Mean Grain Size (um) |
|---------|------|------|------|------|------|
| | R | A | Cu | O | |
| 5-1 | Y: 13.3 | Ba: 41.2 | 28.6 | rem. | 0.7 |
| 5-2 | Er: 22.5 | Ba: 36.9 | 25.6 | rem. | 2.4 |
| 5-3 | Dy: 22.0 | Ba: 37.1 | 25.8 | rem. | 3.1 |
| 5-4 | Yb: 23.1 | Ba: 36.6 | 25.4 | rem. | 2.5 |
| 5-5 | Cd: 21.4 | Ba: 37.4 | 26.0 | rem. | 3.7 |
| 5-6 | Tm: 22.6 | Ba: 36.8 | 25.5 | rem. | 3.2 |
| 5-7 | Nd: 20.0 | Ba: 38.1 | 26.5 | rem. | 4.2 |
| 5-8 | Lu: 23.3 | Ba: 36.5 | 25.3 | rem. | 3.7 |
| 5-9 | Sm: 20.7 | Ba: 37.7 | 26.2 | rem. | 3.5 |
| 5-10 | Y: 13.5 | Ba: 37.7 Sr: 2.7 | 29.0 | rem. | 4.1 |
| 5-11 | Lu: 23.5 | Ba: 35.1 Ca: 0.5 | 25.7 | rem. | 3.0 |
| 5-12 | Same as 5-1 above | | | | |
| 5-13 | Same as 5-2 above | | | | |
| 5-14 | Same as 5-3 above | | | | |
| 5-15 | Same as 5-4 above | | | | |
| 5-16 | Same as 5-5 above | | | | |
| 5-17 | Same as 5-6 above | | | | |
| 5-18 | Same as 5-7 above | | | | |
| 5-19 | Same as 5-8 above | | | | |
| 5-20 | Same as 5-9 above | | | | |
| 5-21 | Same as 5-10 above | | | | |
| 5-22 | Same as 5-11 above | | | | |

Table 5b

| | | | | Oxidative Heat Treatment | | | |
|---|---|---|---|---|---|---|---|
| Run | Theo-retical Density Ratio Aft. Exp. | Area Reduction | Diameter of Wire Rod | Theo-retical Density Ratio | Theo-retical Oxygen Content Ratio | Jc | Tc |
| | (%) | (%) | (mm) | (%) | (%) | (A/cm$^2$) | ($^{\circ}$K) |
| 5-1 | 98.4 | 98 | 1.2 | 98.7 | 99.8 | 6700 | 93 |
| 5-2 | 98.2 | 98 | 1.2 | 98.5 | 99.6 | 3200 | 91 |
| 5-3 | 98.6 | 95 | 1.9 | 98.8 | 99.7 | 4000 | 86 |
| 5-4 | 98.2 | 95 | 1.9 | 98.8 | 99.5 | 5000 | 89 |
| 5-5 | 98.1 | 95 | 1.9 | 98.9 | 99.8 | 5400 | 90 |
| 5-6 | 99.1 | 90 | 2.7 | 99.5 | 99.7 | 4700 | 89 |
| 5-7 | 98.2 | 90 | 2.7 | 98.7 | 99.9 | 3600 | 87 |
| 5-8 | 98.8 | 98 | 1.2 | 98.9 | 99.8 | 4200 | 90 |
| 5-9 | 98.3 | 98 | 1.2 | 98.3 | 99.7 | 3300 | 84 |
| 5-10 | 98.7 | 98 | 1.2 | 98.9 | 99.8 | 4900 | 92 |
| 5-11 | 99.2 | 95 | 1.9 | 99.2 | 99.5 | 5300 | 93 |
| 5-12 | – | Same as 5-1 above | | | 87.2 | 98.8 | 200 | 90 |
| 5-13 | – | Same as 5-2 above | | | 84.5 | 98.7 | 50 | 87 |
| 5-14 | – | Same as 5-3 above | | | 83.1 | 98.7 | 30 | 85 |
| 5-15 | – | Same as 5-4 above | | | 83.6 | 98.8 | 30 | 88 |
| 5-16 | – | Same as 5-5 above | | | 85.2 | 98.8 | 40 | 86 |
| 5-17 | – | Same as 5-6 above | | | 84.7 | 98.7 | 40 | 85 |
| 5-18 | – | Same as 5-7 above | | | 83.8 | 98.8 | 30 | 84 |
| 5-19 | – | Same as 5-8 above | | | 82.5 | 98.8 | 50 | 89 |
| 5-20 | – | Same as 5-9 above | | | 83.0 | 98.9 | 30 | 85 |
| 5-21 | – | Same as 5-10 above | | | 85.0 | 98.9 | 130 | 91 |
| 5-22 | – | Same as 5-11 above | | | 84.0 | 98.8 | 40 | 90 |

Example 6

As starting powder, $R_2O_3$ powder, AO powder and CuO powder each having a predetermined mean grain size of from 0.5 to 10 um were blended at a blend ratio shown in Table 61. After mixing, the resulting mixture was filled into a cylindrical casing made of Ag having a size of 10 mm in inner diameter, 1 mm thick and 100 mm long at a filling ratio of 50% and the casing was sealed in vacuo. Then, the thus-filled casing was was calcined by holding it in the air at a predetermined temperature of 850 to 950 °C to convert the powders in the metal casing into superconducting ceramics, which was then placed upright in the center of a cardboard container having an inner diameter of 500 mm and a height of 200 mm together with 500 g of an explosive. Then, the explosive was fired to apply explosion force to the casing to give rise to shock-compressed body hving a theoretical density ratio shown in Table 6b below. The shock-compressed body was cold processed by subjecting it to swaging and grooved roll-process-ing, each in a plurality of times, followed by drawing the product into wire rod at an area reduction shown in Table 6b below. Then, the wire rod was heat-treated for oxidation at a predetermined temperature of from 300 to 500 °C for 20 to 60 minutes to effect annealing for stress relief, thus producing R-A-Cu-O based superconducting ceramics wire rods.

For comparison, R-A-Cu-O based superconducting ceramics powder having a mean grain size and composition shown in Table 6a was filled in the same cylindrical Ag casing as described above at a filling ration of 50%. After sealing it in vacuo, the casing was immediately cold processed under the same conditions as above to obtain wire rod, which was then heat-treated in the same manner as above to effect annealing for stress relief, thus producing comparative wire rods.

The theoretical density ratio, critical temperature (Tc) and critical current (Jc) of the superconducting ceramics wire rods thus obtained were determined and the results obtained are shown in Table 6c.

From the results shown in Table 6c below, it can be seen that the superconducting ceramics wire rods fabricated according to the process of the present invention had a theoretical density ratio much higher than that of the comparative wire rods. These results correspond to high critical current and high critical temperature.

Table 6a

| | Starting Powder | | |
|---|---|---|---|
| Run No. | Composition (wt.%) | | |
| | $R_2O_3$ | AO | CuO |
| 6-1 | $Y_2O_3$: 17.15 | BaO: 46.59 | rem. |
| 6-2 | $Er_2O_3$: 25.97 | BaO: 41.63 | rem. |
| 6-3 | $Dy_2O_3$: 25.50 | BaO: 41.89 | rem. |
| 6-4 | $Yb_2O_3$: 26.54 | BaO: 41.32 | rem. |
| 6-5 | $Gd_2O_3$: 24.95 | BaO: 42.21 | rem. |
| 6-6 | $Tm_2O_3$: 26.13 | BaO: 41.55 | rem. |
| 6-7 | $Nd_2O_3$: 25.12 | BaO: 42.98 | rem. |
| 6-8 | $Lu_2O_3$: 26.73 | BaO: 41.21 | rem. |
| 6-9 | $Sm_2O_3$: 24.23 | BaO: 42.61 | rem. |
| 6-10 | $Y_2O_3$: 17.41 | BaO: 42.58 SrO: 3.20 | rem. |
| 6-11 | $Lu_2O_3$: 27.09 | BaO: 39.66 CaO: 0.76 | rem. |

Table 6b

| Characteristics of Article | | | |
|---|---|---|---|
| Run | Theoretical Density Ratio Aft. Exp. (%) | Area Reduction (%) | Diameter of Wire Rod (mm) |
| 6-1 | 98.3 | 98 | 1.2 |
| 6-2 | 98.7 | 98 | 1.2 |
| 6-3 | 99.2 | 98 | 1.2 |
| 6-4 | 98.4 | 90 | 2.7 |
| 6-5 | 98.2 | 95 | 1.9 |
| 6-6 | 98.5 | 95 | 1.9 |
| 6-7 | 98.3 | 95 | 1.9 |
| 6-8 | 99.2 | 90 | 2.7 |
| 6-9 | 98.2 | 90 | 2.7 |
| 6-10 | 97.9 | 98 | 1.2 |
| 6-11 | 99.3 | 98 | 1.2 |

Table 6c

| Characteristics of Wire Rod | | |
|---|---|---|
| Run | Theoretical Density Ratio (%) | Critical Current (Jc) (A/cm$^2$) |
| 6-1 | 98.5 | 4900 |
| 6-2 | 98.8 | 2900 |
| 6-3 | 99.3 | 3300 |
| 6-4 | 98.4 | 3200 |
| 6-5 | 98.6 | 3600 |
| 6-6 | 98.9 | 3200 |
| 6-7 | 98.5 | 3500 |
| 6-8 | 99.1 | 3300 |
| 6-9 | 98.4 | 2900 |
| 6-10 | 98.3 | 4200 |
| 6-11 | 99.3 | 4400 |

Table 6a'

| Starting Powder | | | | | |
|---|---|---|---|---|---|
| Run No. | Composition (wt.%) | | | | Mean Grain Size (um) |
| | R | A | Cu | O | |
| 6-12 | Y: 13.3 | Be: 41.2 | 28.6 | rem. | 1.0 |
| 6-13 | Er: 22.5 | Ba: 36.9 | 25.6 | rem. | 3.3 |
| 6-14 | Dy: 22.0 | Ba: 37.1 | 25.8 | rem. | 3.1 |
| 6-15 | Yb: 23.1 | Be: 36.6 | 25.4 | rem. | 3.8 |
| 6-16 | Gd: 21.4 | Ba: 37.4 | 26.0 | rem. | 3.0 |
| 6-17 | Tm: 22.6 | Ba: 36.8 | 25.5 | rem. | 3.5 |
| 6-18 | Nb: 20.0 | Ba: 38.1 | 26.5 | rem. | 3.3 |
| 6-19 | Lu: 23.3 | Ba: 36.5 | 25.3 | rem. | 3.2 |
| 6-20 | Sm: 20.7 | Ba: 37.7 | 26.2 | rem. | 3.6 |
| 6-21 | Y: 13.5 | Ba: 37.7 Sr: 2.7 | 29.0 | rem. | 4.2 |
| 6-22 | Lu: 23.5 | Ba: 35.1 Ca: 0.5 | 25.7 | rem. | 3.4 |

Table 6b'

| Characteristics of Article | | |
|---|---|---|
| Run | Area Reduction (%) | Diameter of Wire Rod (mm) |
| 6-12 | 98 | 1.7 |
| 6-13 | 98 | 1.7 |
| 6-14 | 98 | 1.7 |
| 6-15 | 95 | 2.7 |
| 6-16 | 95 | 2.7 |
| 6-17 | 90 | 3.8 |
| 6-18 | 95 | 2.7 |
| 6-19 | 95 | 2.7 |
| 6-20 | 98 | 1.7 |
| 6-21 | 95 | 2.7 |
| 6-22 | 95 | 2.7 |

Table 6c'

| Characteristics of Wire Rod | | |
|---|---|---|
| Run | Theoretical Density Ratio (%) | Critical Current (Jc) (A/cm$^2$) |
| 6-12 | 89.1 | 200 |
| 6-13 | 87.2 | 50 |
| 6-14 | 86.3 | 70 |
| 6-15 | 82.8 | 100 |
| 6-16 | 83.5 | 70 |
| 6-17 | 81.5 | 70 |
| 6-18 | 84.2 | 50 |
| 6-19 | 84.5 | 30 |
| 6-20 | 87.5 | 30 |
| 6-21 | 85.0 | 150 |
| 6-22 | 84.5 | 40 |

Example 7

As starting powder, $R_2O_3$ powder, AO powder and CuO powder each having a predetermined mean grain size of from 0.5 to 10 um were blended at a blend ratio shown in Table 6a (Example 6). After mixing, the resulting mixture was filled into a cylindrical casing made of Ag having a size of 10 mm in inner diameter, 1 mm thick and 100 mm long at a filling ratio of 50% and the both the end of the casing were sealed. Then, the thus-filled casing was was calcined by holding it in the air at a predetermined temperature of 850 to 950 °C to convert the powders in the metal casing into superconducting ceramics, which was then placed upright in the center of a cardboard container having an inner diameter of 50 mm and a height of 200 mm together with 100 to 500 g of an explosive. Then, the explosive was fired to apply explosion force to the casing to give rise to shock-compressed body hving a theoretical density ratio shown in Table 6b below. The shock-compressed body was cold processed by subjecting it to swaging and grooved roll-process-ing, each in a plurality of times, followed by drawing the product into wire rod at an area reduction shown in Table 7b below. Then, the wire rod was heat-treated for oxidation at a predetermined temperature of from 900 to 940 °C for 8 to 16 hours. thus producing R-A-Cu-O based superconducting ceramics wire rods.

For comparison, R-A-Cu-O based superconducting ceramics powder having a mean grain size and composition shown in Table 6a was filled in the same cylindrical Ag casing as described above at a filling ratio of 50%. After sealing it at the both ends thereof, the casing was immediately cold processed under the same conditions as above to obtain wire rod, which was then heat-treated in the same manner as above to effect annealing for stress relief, thus producing comparative wire rods.

The theoretical density ratio, critical temperature (Tc) and critical current (Jc) of the superconducting ceramics wire rods thus obtained were determined and the results obtained are shown in Table 6c.

From the results shown in Table 7c below, it can be seen that the superconducting ceramics wire rods fabricated according to the process of the present invention had a theoretical density ratio much higher than that of the comparative wire rods. These results correspond to high critical current and high critical temperature.

Table 7a

| Starting Powder | | | |
|---|---|---|---|
| Run No. | Composition (wt.%) | | |
| | $R_2O_3$ | AO | CuO |
| 7-1 | $Y_2O_3$: 17.15 | BaO: 46.59 | rem. |
| 7-2 | $Er_2O_3$: 25.97 | BaO: 41.63 | rem. |
| 7-3 | $Dy_2O_3$: 25.50 | BaO: 41.89 | rem. |
| 7-4 | $Yb_2O_3$: 26.54 | BaO: 41.32 | rem. |
| 7-5 | $Gd_2O_3$: 24.95 | BaO: 42.21 | rem. |
| 7-6 | $Tm_2O_3$: 26.13 | BaO: 41.55 | rem. |
| 7-7 | $Nd_2O_3$: 25.12 | BaO: 42.98 | rem. |
| 7-8 | $Lu_2O_3$: 26.73 | BaO: 41.21 | rem. |
| 7-9 | $Sm_2O_3$: 24.23 | BaO: 42.61 | rem. |
| 7-10 | $Y_2O_3$: 17.41 | BaO: 42.58<br>SrO: 3.20 | rem. |
| 7-11 | $Lu_2O_3$: 27.09 | BaO: 39.66<br>CaO: 0.76 | rem. |

Table 7b

| Characteristics of Article | | | |
|---|---|---|---|
| Run | Theoretical Density Ratio Aft. Exp. (%) | Area Reduction (%) | Diameter of Wire Rod (mm) |
| 7-1 | 98.1 | 90 | 2.7 |
| 7-2 | 98.3 | 80 | 3.8 |
| 7-3 | 99.0 | 85 | 3.3 |
| 7-4 | 98.1 | 80 | 3.8 |
| 7-5 | 98.0 | 90 | 2.7 |
| 7-6 | 98.2 | 90 | 2.7 |
| 7-7 | 97.9 | 80 | 3.8 |
| 7-8 | 98.5 | 85 | 3.3 |
| 7-9 | 98.9 | 85 | 3.3 |
| 7-10 | 97.9 | 80 | 3.8 |
| 7-11 | 98.8 | 90 | 2.7 |

Table 7C

| Characteristics of Wire Rod | | |
|---|---|---|
| Run | Theoretical Density Ratio (%) | Critical Current (Jc) (A/cm$^2$) |
| 7-1 | 98.3 | 5700 |
| 7-2 | 98.5 | 3200 |
| 7-3 | 99.0 | 3100 |
| 7-4 | 98.4 | 3200 |
| 7-5 | 98.2 | 3500 |
| 7-6 | 98.3 | 3400 |
| 7-7 | 98.3 | 3700 |
| 7-8 | 98.9 | 4100 |
| 7-9 | 98.5 | 3600 |
| 7-10 | 98.2 | 4500 |
| 7-11 | 99.0 | 4400 |

Table 7a'

| Starting Powder | | | | | |
|---|---|---|---|---|---|
| Run No. | Composition (wt.%) | | | | Mean Grain Size (um) |
| | R | A | Cu | O | |
| 7-12 | Y: 13.3 | Ba: 41.2 | 28.6 | rem. | 1.0 |
| 7-13 | Er: 22.5 | Ba: 36.9 | 25.6 | rem. | 3.3 |
| 7-14 | Dy: 22.0 | Ba: 37.1 | 25.8 | rem. | 3.1 |
| 7-15 | Yb: 23.1 | Ba: 36.6 | 25.4 | rem. | 3.8 |
| 7-16 | Gd: 21.4 | Ba: 37.4 | 26.0 | rem. | 3.0 |
| 7-17 | Tm: 22.6 | Ba: 36.8 | 25.5 | rem. | 3.5 |
| 7-18 | Nb: 20.0 | Ba: 38.1 | 26.5 | rem. | 3.3 |
| 7-19 | Lu: 23.3 | Ba: 36.5 | 25.3 | rem. | 3.2 |
| 7-20 | Sm: 20.7 | Ba: 37.7 | 26.2 | rem. | 3.6 |
| 7-21 | Y: 13.5 | Ba: 37.7 Sr: 2.7 | 29.0 | rem. | 4.2 |
| 7-22 | Lu: 23.5 | Ba: 35.1 Ca: 0.5 | 25.7 | rem. | 3.4 |

Table 7b'

| Characteristics of Article | | |
|---|---|---|
| Run | Area Reduction (%) | Diameter of Wire Rod (mm) |
| 7-12 | 90 | 3.9 |
| 7-13 | 90 | 3.9 |
| 7-14 | 85 | 4.6 |
| 7-15 | 80 | 4.6 |
| 7-16 | 80 | 5.3 |
| 7-17 | 90 | 3.9 |
| 7-18 | 90 | 3.9 |
| 7-19 | 85 | 4.6 |
| 7-20 | 85 | 4.6 |
| 7-21 | 90 | 3.9 |
| 7-22 | 90 | 3.9 |

Table 7c'

| Characteristics of Wire Rod | | |
|---|---|---|
| Run | Theoretical Density Ratio (%) | Critical Current (Jc) (A/cm$^2$) |
| 7-12 | 81.2 | 210 |
| 7-13 | 87.0 | 60 |
| 7-14 | 87.2 | 70 |
| 7-15 | 83.3 | 120 |
| 7-16 | 84.4 | 80 |
| 7-17 | 81.5 | 80 |
| 7-18 | 84.3 | 60 |
| 7-19 | 84.1 | 40 |
| 7-20 | 88.2 | 40 |
| 7-21 | 86.2 | 160 |
| 7-22 | 84.1 | 30 |

Example 8

As starting powder, $R_2O_3$ powder, AO powder and CuO powder each having a predetermined mean grain size of from 0.5 to 10 um were blended at a blend ratio shown in Table 8a. After mixing, the resulting mixture was filled into a cylindrical casing made of Ag having a size of 10 mm in inner diameter, 1 mm thick and 100 mm long at a filling ratio of 50% and the casing was sealed in vacuo. Then, the thus-filled casing was then placed upright in the center of a cardboard container having an inner diameter of 500 mm and a height of 200 mm together with 500 g of an explosive. Then, the explosive was fired to apply explosion force to the casing to give rise to shock-compressed body. The shock-compressed body together with the metal casing was calcined by holding it in the air at a predetermined temperature of 850 to 950 °C to convert the powders in the metal casing into supercoducting ceramics. The superconducting ceramics compressed body (shock-compressed calcined body) had a high theoretical density ratio shown in Table 8. The shock-compressed body was cold processed by subjecting it to swaging and grooved roll-process-ing, each in a plurality of times, followed by drawing the product into wire rod at an area reduction shown in Table 8a below. Then, the wire rod was heat-treated for oxidation at a predetermined temperature of from 300 to 500 °C for 20 to 60 minutes to effect annealing for stress relief, thus producing R-A-Cu-O based superconducting ceramics wire rods.

For comparison, R-A-Cu-O based superconducting ceramics powder having a mean grain size and composition shown in Table 8b was filled in the same cylindrical Ag casing as described above at a filling ratio of 50%. After sealing it in vacuo, the casing was immediately cold processed under the same conditions as above to obtain wire rod, which was then heat-treated in the same manner as above to effect annealing for stress relief, thus producing comparative wire rods.

The theoretical density ratio, critical temperature (Tc) and critical current (Jc) of the superconducting ceramics wire rods thus obtained were determined and the results obtained are shown in Tables 8a and 8b.

From the results shown in Tables 8a and 8b below, it can be seen that the superconducting ceramics wire rods fabricated according to the process of the present invention had a theoretical density ratio much higher than that of the comparative wire rods. These results correspond to high critical current.

Table 8a

| | Run No. | Composition (wt·%) | | | Theoretical Density Ratio (%) | Area Reduction (%) | Diameter of Wire Rod (mm) | Characteristics of Article | |
|---|---|---|---|---|---|---|---|---|---|
| | | R₂O₃ | A O | Cu O | | | | Theoretical Density Ratio (%) | J c (A/cm) |
| Run No. | 8-1 | Y₂O₃ : 17.15 | Ba O : 46.59 | rem. | 98.5 | 98 | 1.2 | 98.1 | 4.200 |
| | 8-2 | Er₂O₃ : 25.97 | Ba O : 41.63 | rem. | 97.9 | 95 | 1.9 | 97.4 | 2.700 |
| | 8-3 | Dy₂O₃ : 25.50 | Ba O : 41.89 | rem. | 98.4 | 95 | 1.9 | 98.1 | 3.100 |
| | 8-4 | Yb₂O₃ : 26.54 | Ba O : 41.32 | rem. | 98.7 | 98 | 1.2 | 98.2 | 3.000 |
| | 8-5 | Gd₂O₃ : 24.95 | Ba O : 42.21 | rem. | 99.2 | 98 | 1.2 | 98.5 | 3.400 |
| | 8-6 | Ta₂O₃ : 26.13 | Ba O : 41.55 | rem. | 97.8 | 90 | 2.7 | 97.5 | 2.700 |
| | 8-7 | Nd₂O₃ : 25.12 | Ba O : 42.98 | rem. | 98.5 | 95 | 1.9 | 97.2 | 2.900 |
| | 8-8 | Lu₂O₃ : 26.73 | Ba O : 41.21 | rem. | 99.1 | 95 | 1.9 | 98.8 | 3.100 |
| | 8-9 | Sm₂O₃ : 24.23 | Ba O : 42.61 | rem. | 99.0 | 98 | 1.2 | 97.5 | 2.400 |
| | 8-10 | Y₂O₃ : 17.41 | Ba O : 42.58<br>Sr O : 3.20 | rem. | 98.6 | 90 | 2.7 | 98.3 | 3.900 |
| | 8-11 | Lu₂O₃ : 27.09 | Ba O : 39.66<br>Ca O : 0.76 | rem. | 99.2 | 90 | 2.7 | 98.8 | 3.900 |

EP 0 296 639 B1

## Example 9

As starting powder, $R_2O_3$ powder, AO powder and CuO powder each having a predetermined mean grain size of from 0.5 to 10 um were blended at a blend ratio shown in Table 8a. After mixing, the resulting

## Table 8b

| Run No. | Starting Powder Composition ( wt % ) | | | | Mean Grain Size ( μm ) | Area Reduction ( % ) | Diameter of Wire Rod ( mm ) | Characteristics of Article | |
|---|---|---|---|---|---|---|---|---|---|
| | R | A | Cu | O | | | | Theoretical Density Ratio ( % ) | Jc ( A/cm² ) |
| 8-12 | Y : 13.3 | Ba : 41.2 | 28.6 | Rem. | 1.3 | 98 | 1.7 | 87.7 | 190 |
| 8-13 | Er : 22.5 | Ba : 36.9 | 25.6 | Rem. | 4.2 | 98 | 1.7 | 86.9 | 60 |
| 8-14 | Dy : 22.0 | Ba : 37.1 | 25.8 | Rem. | 3.8 | 95 | 2.7 | 84.3 | 70 |
| 8-15 | Yb : 23.1 | Ba : 36.6 | 25.4 | Rem. | 3.9 | 95 | 2.7 | 83.8 | 40 |
| 8-16 | Gd : 21.4 | Ba : 37.4 | 26.0 | Rem. | 3.6 | 95 | 2.7 | 85.2 | 30 |
| 8-17 | Tm : 22.6 | Ba : 36.8 | 25.5 | Rem. | 3.8 | 90 | 3.8 | 81.9 | 40 |
| 8-18 | Nd : 20.0 | Ba : 38.1 | 26.5 | Rem. | 3.5 | 90 | 3.8 | 83.4 | 60 |
| 8-19 | Lu : 23.3 | Ba : 36.5 | 25.3 | Rem. | 4.2 | 90 | 3.8 | 82.7 | 30 |
| 8-20 | Sm : 20.7 | Ba : 37.7 | 26.2 | Rem. | 3.1 | 95 | 2.7 | 86.3 | 90 |
| 8-21 | Y : 13.5 | Ba : 37.7, Sr : 2.7 | 29.0 | Rem. | 3.6 | 98 | 1.7 | 88.9 | 110 |
| 8-22 | Lu : 23.5 | Ba : 35.1, Ca : 0.5 | 25.7 | Rem. | 3.0 | 98 | 1.7 | 89.3 | 120 |

mixture was filled into a cylindrical casing made of Ag having a size of 10 mm in inner diameter, 1 mm thick and 100 mm long at a filling ratio of 50% and the both ends of the casing was sealed in vacuo. Then, the thus-filled casing was then placed upright in the center of a cardboard container having an inner diameter of 50 mm and a height of 200 mm together with 100 to 500 g of an explosive. Then, the explosive was fired to apply explosion force to the casing to give rise to shock-compressed body. The shock-compressed body together with the metal casing was calcined by holding it in the air at a predetermined temperature of 850 to 950 °C to convert the powders in the metal casing into supercoducting ceramics. The superconducting ceramics compressed body (shock-compressed calcined body) had a high theoretical density ratio shown in Table 9a. The shock-compressed body was cold processed by subjecting it to swaging and grooved roll-process-ing, each in a plurality of times, followed by drawing the product into wire rod at an area reduction shown in Table 9a below. Then, the wire rod was heat-treated at a predetermined temperature of from 900 to 940 °C for 8 to 16 hours, thus producing R-A-Cu-O based superconducting ceramics wire rods.

For comparison, R-A-Cu-O based superconducting ceramics powder having a mean grain size and composition shown in Table 9b was filled in the same cylindrical Ag casing as described above at a filling ratio of 50%. After sealing the both ends of the casing in vacuo, the casing was immediately cold processed under the same conditions as above to obtain wire rod, which was then heat-treated in the same manner as above, thus producing comparative wire rods.

The theoretical density ratio, critical temperature (Tc) and critical current (Jc) of the superconducting ceramics wire rods thus obtained were determined and the results obtained are shown in Tables 9a and 9b.

From the results shown in Table 9a and 9b below, it can be seen that the superconducting ceramics wire rods fabricated according to the process of the present invention had a theoretical density ratio much higher than that of the comparative wire rods. These results correspond to high critical current.

## Table 9a

| | | Composition (wt-%) | | | Theoretical Density Ratio (%) | Area Reduction (%) | Diameter of Wire Rod (mm) | Characteristics of Article | |
|---|---|---|---|---|---|---|---|---|---|
| | | R₂O₃ | A O | Cu O | | | | Theoretical Density Ratio (%) | J c (A/cd) |
| Run No. | 8-1 | Y₂O₃ : 17.15 | Ba O : 46.59 | rem. | 98.0 | 90 | 2.7 | 98.0 | 4800 |
| | 8-2 | Er₂O₃ : 25.97 | Ba O : 41.63 | rem. | 97.8 | 85 | 3.3 | 97.5 | 2800 |
| | 8-3 | Dy₂O₃ : 25.50 | Ba O : 41.89 | rem. | 98.3 | 80 | 3.8 | 98.0 | 3800 |
| | 8-4 | Yb₂O₃ : 26.54 | Ba O : 41.32 | rem. | 98.4 | 80 | 3.8 | 98.1 | 2900 |
| | 8-5 | Gd₂O₃ : 24.95 | Ba O : 42.21 | rem. | 99.0 | 90 | 2.7 | 98.3 | 3500 |
| | 8-6 | Tm₂O₃ : 26.13 | Ba O : 41.55 | rem. | 97.3 | 90 | 2.7 | 97.8 | 3000 |
| | 8-7 | Nd₂O₃ : 25.12 | Ba O : 42.98 | rem. | 98.2 | 90 | 2.7 | 97.4 | 2600 |
| | 8-8 | Lu₂O₃ : 26.73 | Ba O : 41.21 | rem. | 99.0 | 90 | 2.7 | 98.3 | 3400 |
| | 8-9 | Sm₂O₃ : 24.23 | Ba O : 42.61 | rem. | 99.0 | 80 | 3.8 | 97.9 | 2700 |
| | 8-10 | Y₂O₃ : 17.41 | Ba O : 42.58 / Sr O : 3.20 | rem. | 98.4 | 85 | 3.3 | 98.2 | 3900 |
| | 8-11 | Lu₂O₃ : 27.09 | Ba O : 39.66 / Ca O : 0.76 | rem. | 99.1 | 80 | 3.8 | 98.7 | 3700 |

EP 0 296 639 B1

Table 9b

| Run No. | Starting Powder Composition ( wt %) R | A | Cu | O | Mean Grain Size (μm) | Area Reduction (%) | Diameter of Wire Rod (mm) | Characteristics of Article Theoretical Density Ratio (%) | Jc (A/cm²) |
|---|---|---|---|---|---|---|---|---|---|
| 8-12 | Y : 13.3 | Ba : 41.2 | 28.6 | Rem. | 1.3 | 90 | 3.9 | 87.5 | 250 |
| 8-13 | Er : 22.5 | Ba : 36.9 | 25.6 | Rem. | 4.2 | 90 | 3.9 | 88.0 | 70 |
| 8-14 | Dy : 22.0 | Ba : 37.1 | 25.8 | Rem. | 3.8 | 85 | 4.6 | 83.5 | 60 |
| 8-15 | Yb : 23.1 | Ba : 36.6 | 25.4 | Rem. | 3.9 | 80 | 5.3 | 81.2 | 50 |
| 8-16 | Gd : 21.4 | Ba : 37.4 | 26.0 | Rem. | 3.6 | 80 | 5.3 | 84.0 | 40 |
| 8-17 | Tm : 22.6 | Ba : 36.8 | 25.5 | Rem. | 3.8 | 90 | 3.9 | 82.5 | 40 |
| 8-18 | Nd : 20.0 | Ba : 38.1 | 26.5 | Rem. | 3.5 | 90 | 3.9 | 82.0 | 50 |
| 8-19 | Lu : 23.3 | Ba : 36.5 | 25.3 | Rem. | 4.2 | 85 | 4.6 | 81.9 | 60 |
| 8-20 | Sm : 20.7 | Ba : 37.7 | 26.2 | Rem. | 3.1 | 85 | 4.6 | 84.9 | 80 |
| 8-21 | Y : 13.5 | Ba : 37.7 / Sr : 2.7 | 29.0 | Rem. | 3.6 | 80 | 5.3 | 87.5 | 120 |
| 8-22 | Lu : 23.5 | Ba : 35.1 / Ca : 0.5 | 25.7 | Rem. | 3.0 | 90 | 3.9 | 86.0 | 120 |

Example 10

As starting powder, $R_2O_3$ powder, AO powder and CuO powder haviong a predetermined mean grain size of form 0.5 to 10 um and various metal oxide powders were blended at a blend ratio shown in Table 10a. After mixing, the resulting mixture was filled into a cylindrical casing made of Cu having a size of 10

34

mm in inner diameter, 1 mm thick and 100 mm long at a filling ratio of 50% and the casing was sealed in vacuo. The metal casing was calcined by holding it in the air at a predetermined temperature of 850 to 950 °C to convert the powders in the metal casing into supercoducting ceramics. Then, the thus-synthesized ceramics was then placed upright in the center of a cardboard container having an inner diameter of 500 mm and a height of 200 mm together with 500 g of an explosive. Then, the explosive was fired to apply explosion force to the casing to give rise to shock-compressed body having a theoretical density ratio shown in Table 10a. The superconducting ceramics compressed body (shock-compressed calcined body) had a high theoretical density ratio shown in Table 10a. The shock-compressed body was cold processed by subjecting it to swaging and grooved roll-processing, each in a plurality of times, followed by drawing the product into wire rod at an area reduction shown in Table 10a below. Then, the wire rod was heat-treated for oxidation at a predetermined temperature of from 300 to 500 °C for 10 to 20 minutes to effect annealing for stress relief, thus producing R-A-Cu-O based superconducting ceramics wire rods.

For comparison, R-A-Cu-O based superconducting ceramics powder having a mean grain size and composition shown in Table 10b was filed in the same cylindrical Ag casing as described above at a filling ratio of 50%. After sealing it in vacuo, the casing was immediately cold processed under the same conditions as above to obtain wire rod, which was then heat-treated in the same manner as above to effect annealing for stress relief, thus producing comparative wire rods.

The theoretical density ratio, critical temperature (Tc) and critical current (Jc) of the superconducting ceramics wire rods thus obtained were determined and the results obtained are shown in Tables 10a and 10b.

From the results shown in Tables 10a and 10b below, it can be seen that the superconducting ceramics wire rods fabricated according to the process of the present invention had a theoretical density ratio and theoretical oxygen content ratio much higher than those of the comparative wire rods. These results correspond to high critical current and high critical temperature.

Table 10a

| | | Composition (wt %) | | | | Theoretical Density Ratio (%) | Area Reduction (%) | Diameter of Wire Rod (mm) | Characteristics of Article | | | |
|---|---|---|---|---|---|---|---|---|---|---|---|---|
| | | $R_2O_3$ | AO | CuO | oxidized metal | | | | Theoretical Density Ratio (%) | Theoretical Contained Oxigen Ratio (%) | Jc (A/cm) | Tc (°K) |
| Run No. | 1 | $Y_2O_3$ : 16.81 | Ba O : 45.66 | rest | $Ag_2O$ : 2 | 98.2 | 98 | 1.2 | 98.5 | 99.9 | 4.700 | 98 |
| | 2 | $Er_2O_3$ : 25.71 | Ba O : 41.21 | rest | $WO_3$ : 1 | 98.5 | 98 | 1.2 | 98.6 | 99.8 | 2.800 | 97 |
| | 3 | $Dy_2O_3$ : 25.19 | Ba O : 41.39 | rest | $V_2O_3$ : 1.2 | 98.0 | 98 | 1.2 | 99.0 | 99.8 | 3.000 | 97 |
| | 4 | $Yb_2O_3$ : 26.14 | Ba O : 40.70 | rest | $Tl_3O_5$ : 1.5 | 97.9 | 90 | 2.7 | 98.2 | 99.3 | 3.000 | 93 |
| | 5 | $Gd_2O_3$ : 24.83 | Ba O : 41.15 | rest | $Ag_2O$ : 2 $\quad$ $MnO_2$ : 0.5 | 98.0 | 95 | 1.9 | 98.5 | 99.8 | 3.800 | 95 |
| | 6 | $Tm_2O_3$ : 25.82 | Ba O : 41.05 | rest | $MoO_3$ : 1.2 | 98.1 | 95 | 1.9 | 98.6 | 99.9 | 3.100 | 99 |
| | 7 | $Nd_2O_3$ : 23.34 | Ba O : 42.55 | rest | $Tl_3O_5$ : 1 | 98.3 | 95 | 1.9 | 99.0 | 99.8 | 3.200 | 97 |
| | 8 | $Lu_2O_3$ : 26.20 | Ba O : 40.39 | rest | $Ag_2O$ : 1 $\quad$ $V_2O_3$ : 0.5 $\quad$ $MoO_3$ : 0.5 | 98.2 | 90 | 2.7 | 98.8 | 99.8 | 3.150 | 97 |
| | 9 | $Sm_2O_3$ : 23.50 | Ba O : 41.33 | rest | $MnO_2$ : 3 | 97.5 | 90 | 2.7 | 99.9 | 99.8 | 2.650 | 96 |
| | 10 | $Y_2O_3$ : 16.54 | Ba O : 40.45 $\quad$ Sr O : 3.04 | rest | $Ag_2O$ : 5 | 97.5 | 98 | 1.2 | 98.6 | 99.9 | 4.200 | 100 |
| | 11 | $Lu_2O_5$ : 26.01 | Ba O : 38.07 $\quad$ Ca O : 0.73 | rest | $WO_3$ : 2 $\quad$ $Tl_3O_5$ : 2 | 97.2 | 98 | 1.2 | 99.3 | 99.2 | 4.000 | 95 |

EP 0 296 639 B1

36

## Example 11

As starting powder, $R_2O_3$ powder, AO powder and CuO powder each having a predetermined mean gain size of from 0.5 to 10 um were blended at a blend ratio shown in Table 11a. After mixing, the resulting

## Table 10b

| Run No. | | Starting Powder Composition (wt %) | | | | Mean grain Size (μm) | Theoretical Density Ratio (%) | Area Reduction (%) | Diameter of wire Rod (mm) | Characteristics of Article | | | |
| | | R | A | Cu | O | | | | | Theoretical Density Ratio (%) | Theoretical Contained Oxigen Ratio (%) | Jc (A/cd) | Tc (°K) |
|---|---|---|---|---|---|---|---|---|---|---|---|---|---|
| Run No. | 1 | Y : 13.3 | Ba : 41.2 | 28.6 | rest | 1.0 | | — | same to formed | 89.2 | 98.1 | 200 | 82 |
| | 2 | Er : 22.5 | Ba : 36.9 | 25.6 | rest | 3.3 | | — | same to 2 | 87.2 | 98.2 | 100 | 80 |
| | 3 | Dy : 22.0 | Ba : 37.1 | 25.8 | rest | 3.1 | | — | same to 3 | 86.0 | 98.1 | 70 | 77 |
| | 4 | Yb : 23.1 | Ba : 36.6 | 25.4 | rest | 3.7 | | — | same to 4 | 82.0 | 98.6 | 20 | 77 |
| | 5 | Gd : 21.4 | Ba : 37.4 | 26.0 | rest | 3.0 | | — | same to 5 | 84.0 | 98.2 | 30 | 79 |
| | 6 | Tm : 22.6 | Ba : 36.8 | 25.5 | rest | 3.4 | | — | same to 6 | 82.6 | 98.9 | 25 | 84 |
| | 7 | Nd : 20.0 | Ba : 38.1 | 26.5 | rest | 3.3 | | — | same to 7 | 83.9 | 99.0 | 28 | 86 |
| | 8 | Lu : 23.3 | Ba : 36.5 | 25.3 | rest | 3.2 | | — | same to 8 | 84.5 | 98.9 | 35 | 83 |
| | 9 | Sm : 20.7 | Ba : 37.7 | 26.2 | rest | 3.5 | | — | same to 9 | 86.8 | 98.7 | 80 | 82 |
| | 10 | Y : 13.5 | Ba : 37.7 Sr : 2.7 | 29.0 | rest | 4.0 | | — | same to 10 | 88.9 | 99.1 | 180 | 89 |
| | 11 | Lu : 23.5 | Ba : 35.1 Ca : 0.5 | 25.7 | rest | 3.3 | | — | same to 11 | 87.5 | 98.9 | 120 | 86 |

mixture was filled into a cylindrical casing made of Cu having a size of 10 mm in inner diameter, 1 mm thick and 100 mm long at a filling ratio of 50% and the casing was sealed in vacuo. Then, the thus-filled casing was then placed upright in the center of a cardboard container having an inner diameter of 500 mm and a height of 200 mm together with 500 g of an explosive. Then, the explosive was fired to apply explosion force to the casing to give rise to shock-compressed body. The shock-compressed body together with the metal casing was calcined by holding it in the air at a predetermined temperature of 850 to 950 °C to convert the powders in the metal casing into supercoducting ceramics. The superconducting ceramics compressed body (shock-compressed calcined body) had a high theoretical density ratio shown in Table 11a. The shock-compressed body was cold processed by subjecting it to swaging and grooved roll-process-ing, each in a plurality of times, followed by drawing the product into wire rod at an area reduction shown in Table 8a below. Then, the wire rod was heat-treated for oxidation at a predetermined temperature of from 300 to 500 °C for 10 to 20 minutes to effect annealing for stress relief, thus producing R-A-Cu-O based superconducting ceramics wire rods.

For comparison, R-A-Cu-O based superconducting ceramics powder having a mean grain size and composition shown in Table 8b was filled in the same cylindrical Ag casing as described above at a filling ratio of 50%. After sealing it in vacuo, the casing was immediately cold processed under the same conditions as above to obtain wire rod, which was then heat-treated in the same manner as above to effect annealing for stress relief, thus producing comparative wire rods.

The theoretical density ratio, critical temperature (Tc) and critical current (Jc) of the superconducting ceramics wire rods thus obtained were determined and the results obtained are shown in Tables 11a and 11b.

From the results shown in Tables 11a and 11b below, it can be seen that the superconducting ceramics wire rods fabricated according to the process of the present invention had a theoretical density ratio much higher than that of the comparative wire rods. These results correspond to high critical current.

## Table 11a

| Run No. | Composition ( wt. % ) | | | | Theoretical Density Ratio Aft. Exp. (%) | Area Reduction ( % ) | Diameter of Wire Rod ( mm ) | Characteristics of Wire Rod | | | |
|---|---|---|---|---|---|---|---|---|---|---|---|
| | $R_2O_3$ | AO | Cu O | Metallic Oxide | | | | Theoretical Density Ratio ( % ) | Theoretical Oxygen Content Ratio ( % ) | Critical Current (Jc) (A/cm) | Critical Temperature (Tc) (°K) |
| 1 | $Y_2O_3$ : 16.81 | Ba O : 45.66 | rem. | $Ag_2O$ : 2 | 98.2 | 98 | 1.2 | 98.4 | 99.9 | 4.600 | 98 |
| 2 | $Er_2O_3$ : 25.71 | Ba O : 41.21 | rem. | $WO_3$ : 1 | 98.5 | 98 | 1.2 | 98.6 | 99.8 | 2.800 | 97 |
| 3 | $Dy_2O_3$ : 25.19 | Ba O : 41.39 | rem. | $V_2O_3$ : 1.2 | 98.0 | 98 | 1.2 | 99.0 | 99.8 | 3.000 | 97 |
| 4 | $Yb_2O_3$ : 26.14 | Ba O : 40.70 | rem. | $Tl_3O_5$ : 1.5 | 97.8 | 90 | 2.7 | 98.2 | 99.3 | 3.000 | 93 |
| 5 | $Gd_2O_3$ : 24.33 | Ba O : 41.15 | rem. | $Ag_2O$ : 2 $MnO_2$ : 0.5 | 97.9 | 95 | 1.9 | 98.2 | 99.8 | 3.300 | 95 |
| 6 | $Tm_2O_3$ : 25.82 | Ba O : 41.05 | rem. | $MoO_3$ : 1.2 | 98.2 | 95 | 1.9 | 98.5 | 99.9 | 3.000 | 99 |
| 7 | $Nd_2O_3$ : 23.34 | Ba O : 42.55 | rem. | $Tl_3O_5$ : 1 | 98.3 | 95 | 1.9 | 99.0 | 99.8 | 3.200 | 97 |
| 8 | $Lu_2O_3$ : 26.20 | Ba O : 40.39 | rem. | $Ag_2O$ : 1 $V_2O_3$ : 0.5 $MoO_3$ : 0.5 | 98.1 | 90 | 2.7 | 98.7 | 99.8 | 3.100 | 97 |
| 9 | $Sm_2O_3$ : 23.50 | Ba O : 41.33 | rem. | $MnO_2$ : 3 | 97.5 | 90 | 2.7 | 99.9 | 99.8 | 2.600 | 96 |
| 10 | $Y_2O_3$ : 16.54 | Ba O : 40.45 Sr O : 3.04 | rem. | $Ag_2O$ : 5 | 97.2 | 98 | 1.2 | 98.5 | 99.9 | 4.000 | 100 |
| 11 | $Lu_2O_3$ : 26.01 | Ba O : 38.07 Ca O : 0.73 | rem. | $WO_3$ : 2 $Tl_3O_5$ : 2 | 97.2 | 98 | 1.2 | 98.8 | 99.2 | 4.000 | 95 |

Table IIb

| Run No. | Starting Powder Composition (wt.%) R | A | Cu | O | Mean Grain Size (μm) | Theoretical Density Ratio Aft. Exp. (%) | Area Reduction (%) | Diameter of Wire Rod (mm) | Characteristics of Wire Rod Theoretical Density Ratio (%) | Theoretical Oxygen Content Ratio (%) | Jc (A/cd) | Tc (°K) |
|---|---|---|---|---|---|---|---|---|---|---|---|---|
| 1 | Y : 13.9 | Ba : 41.2 | 28.6 | rem. | 1.0 | — | | Same to former 1 | 89.1 | 98.1 | 200 | 82 |
| 2 | Er : 22.5 | Ba : 36.9 | 25.6 | rem. | 3.3 | — | | Same to 2 | 87.2 | 98.2 | 100 | 80 |
| 3 | Dy : 22.0 | Ba : 37.1 | 25.8 | rem. | 3.1 | — | | Same to 3 | 85.9 | 98.1 | 20 | 77 |
| 4 | Yb : 23.1 | Ba : 36.6 | 25.4 | rem. | 3.7 | — | | Same to 4 | 81.9 | 98.6 | 10 | 77 |
| 5 | Gd : 21.4 | Ba : 37.4 | 26.0 | rem. | 3.0 | — | | Same to 5 | 83.6 | 98.2 | 30 | 78 |
| 6 | Tm : 22.6 | Ba : 36.8 | 25.5 | rem. | 3.4 | — | | Same to 6 | 82.5 | 98.9 | 40 | 83 |
| 7 | Nd : 20.0 | Ba : 38.1 | 26.5 | rem. | 3.3 | — | | Same to 7 | 83.3 | 98.9 | 50 | 84 |
| 8 | Lu : 23.9 | Ba : 36.5 | 25.3 | rem. | 3.2 | — | | Same to 8 | 82.5 | 98.9 | 10 | 85 |
| 9 | Sm : 20.7 | Ba : 37.7 | 26.2 | rem. | 3.5 | — | | Same to 9 | 86.5 | 98.7 | 150 | 83 |
| 10 | Y : 13.5 Sr : 2.7 | Ba : 37.7 | 29.0 | rem. | 4.0 | — | | Same to 10 | 86.3 | 99.0 | 200 | 87 |
| 11 | Lu : 23.5 Ca : 0.5 | Ba : 35.1 | 25.7 | rem. | 3.3 | — | | Same to 11 | 87.4 | 98.9 | 190 | 82 |

As described above, the superconducting ceramics materials fabricated according to the present invention shown a theoretical density ratio and a theoretical oxygen content ratio much higher than the superconducting ceramics materials fabricated according to the conventional processes.

**Claims**

1. A process for fabricating superconducting ceramics material composed essentially of a yttrium-

40

including rare earth element, an alkaline earth metal, copper and balance oxygen and unavoidable impurities, and optionally containing a metal originating from an oxygen supply agent, comprising:

(a) providing starting powder composed of:

(i) a member selected from the group consisting of:

(1) a mixed powder composed of powders of:

(1-1) a yttrium-including rare earth element oxide,

(1-2) an alkaline earth metal oxide, and

(1-3) copper oxide,

the mixture having a composition substantially the same as that of a contemplated superconducting ceramics,

(2) a mixed powder composed of powders of:

(2-1) a partial compound between any two of the component oxides constituting a contemplated superconductive ceramics selected from (1-1), (1-2) and (1-3), and

(2-2) the rest of the component oxides selected from (1-1), (1-2) and (1-3),

the mixture having a composition substantially the same as that of a contemplated superconducting ceramics,

(3) powder of a superconducting ceramics composed essentially of a yttrium-including rare earth element, an alkaline earth metal, copper and balance oxygen and unavoidable impurities,

(4) a mixed powder composed of at least two members selected from the mixed powders (1), (2) and (3); and

(ii) optionally an oxygen-supply agent;

(b) placing said starting powder in a metal casing and sealing said metal casing;

(c) applying explosion force to said starting powder from outside of said metal casing to render said starting powder shock-compressed;

(d) optionally heat-treating said starting powder when said starting powder is the mixed powder (1), (2) or (4) at a temperature sufficient for calcining said starting powder prior to or after said application of explosion force;

(e) processing said explosively compressed product to produce an article having a predetermined form; and

(f) optionally heat-treating said article at a temperature of from 300 °C to 950 °C.

2. The process as claimed in Claim 1, wherein said starting powder is the mixed powder (1) and/or (2) and/or (4).

3. The process as claimed in Claim 2, wherein said starting powder is composed of the mixed powder (1).

4. The process as claimed in Claim 3, wherein said yttrium-including rare earth element oxide (1-1) is yttrium oxide.

5. The process as claimed in Claim 4, wherein said alkaline earth metal oxide (1-2) is barium oxide.

6. The process as claimed in Claim 2, wherein said starting powder is composed of the mixed powder (1) and/or (2) and/or (4) and the oxygen-supply agent.

7. The process as claimed in Claim 6, wherein said starting powder is composed of (1) and the oxygen-supply agent.

8. The process as claimed in Claim 7, wherein said yttrium-including rare earth element oxide is yttrium oxide.

9. The process as claimed in Claim 8, wherein said alkaline earth metal oxide (1-2) is barium oxide.

10. The process as claimed in claim 1, wherein said heat-treatment (d) is performed prior to said application of explosion force.

11. The process as claimed in Claim 1, wherein said heat-treatment is performed after said application of explosion force.

**12.** The process as claimed in Claim 2, wherein said starting powder is composed of the powder (3).

**13.** The process as claimed in Claim 12, wherein said yttrium-including rare earth element oxide (1-1) is yttrium oxide.

**14.** The process as claimed in Claim 13, wherein said alkaline earth metal oxide (1-2) is barium oxide.

**15.** The process as claimed in Claim 2, wherein said starting powder is composed of the powder (3) and powder of the oxygen-supply agent.

**16.** The process as claimed in Claim 15, wherein said yttrium-including rare earth element oxide (1-1) is yttrium oxide.

**17.** The process as claimed in Claim 16, wherein said alkaline earth metal oxide (1-2) is barium oxide.

**18.** The process as claimed in Claim 1, further comprising providing an oxide layer on the inner surface of said metal casing.

**19.** The process as claimed in Claim 1, wherein said heat-treatment (f) is performed at a temperature of from 300 °C to 950 °C.

**20.** The process as claimed in Claim 19, wherein said heat-treatment (f) is performed at a temperature of from 850 °C to 950 °C.

**21.** The process as claimed in Claim 20, wherein said heat treatment (f) is performed at a temperature of from 900 °C to 940 °C.

**22.** The process as claimed in Claim 1, wherein said metal casing is made of a metal selected from the group consisting of copper, silver, and aluminum, and alloys thereof.

**23.** The process as claimed in Claim 22, wherein said metal casing is made of silver and its alloy.

**24.** The process as claimed in Claim 1, wherein said oxygen-supply agent is $Ag_2O$, $MnO_2$, $MoO_3$, $WO_3$, $V_2O_5$ or $Ti_3O_5$.

**25.** The process as claimed in Claim 24, wherein said oxygen-supply agent is $Ag_2O$.

**Revendications**

**1.** Procédé de production d'une matière céramique supraconductrice essentiellement composée d'un élément des terres rares renfermant de l'yttrium, d'un métal alcalino-terreux, de cuivre, le reste étant formé d'oxygène et d'impuretés inévitables, et contenant facultativement un métal provenant d'un agent source d'oxygène, qui consiste :

(a) à prendre une poudre de départ constituée :

(i) d'un composant choisi dans le groupe comprenant :

(1) une poudre mixte formée de poudres :

(1-1) d'un oxyde d'éléments des terres rares renfermant de l'yttrium,

(1-2) d'un oxyde de métal alcalino-terreux, et

(1-3) d'oxyde de cuivre,

le mélange ayant une composition pratiquement identique à celle d'une matière céramique supraconductrice envisagée,

(2) une poudre mixte constituée de poudres :

(2-1) d'une combinaison partielle entre deux quelconques des oxydes constitutifs d'une matière céramique supraconductrice envisagée, choisis entre (1-1), (1-2) et (1-3), et

(2-2) du reste des oxydes constitutifs choisis entre (1-1), (1-2) et (1-3),

le mélange ayant pratiquement la même composition que la matière céramique supraconductrice envisagée,

(3) une poudre d'une matière supraconductrice essentiellement composée d'un élément des terres rares renfermant de l'yttrium, d'un métal alcalino-terreux, de cuivre, le reste étant constitué d'oxygène et des impuretés inévitables,

(4) une poudre mixte composée d'au moins deux constituants choisis parmi les poudres mixtes (1), (2) et (3) : et

(ii) à titre facultatif, d'un agent apportant de l'oxygène ;

(b) à placer ladite poudre de départ dans une enveloppe métallique et à fermer cette enveloppe métallique ;

(c) à exercer une force explosive sur ladite poudre de départ depuis l'extérieur de l'enveloppe métallique pour que ladite poudre de départ soit comprimée par le choc ;

(d) le cas échéant, à traiter thermiquement ladite poudre de départ lorsque cette poudre est la poudre mixte (1), (2) ou (4) à une température suffisante pour calciner cette poudre de départ avant ou après l'application de la force explosive ;

(e) à traiter le produit comprimé par explosion pour obtenir un article ayant une forme prédéterminée ; et

(f) le cas échéant, à traiter thermiquement cet article à une température de 300 à 950°C.

2. Procédé suivant la revendication 1, dans lequel la poudre de départ est la poudre mixte (1) et/ou (2) et/ou (4).

3. Procédé suivant la revendication 2, dans lequel la poudre de départ est composée de la poudre mixte (1).

4. Procédé suivant la revendication 3, dans lequel l'oxyde (1-1) d'éléments des terres rares renfermant de l'yttrium est l'oxyde d'yttrium.

5. Procédé suivant la revendication 4, dans lequel l'oxyde de métal alcalino-terreux (1-2) est l'oxyde de baryum.

6. Procédé suivant la revendication 2, dans lequel la poudre de départ est composée de la poudre mixte (1) et/ou (2) et/ou (4) et de l'agent apportant de l'oxygène.

7. Procédé suivant la revendication 6, dans lequel la poudre de départ est composée de (1) et de l'agent apportant de l'oxygène.

8. Procédé suivant la revendication 7, dans lequel l'oxyde d'éléments des terres rares renfermant de l'yttrium est l'oxyde d'yttrium.

9. Procédé suivant la revendication 8, dans lequel l'oxyde de métal alcalino-terreux (1-2) est l'oxyde de baryum.

10. Procédé suivant la revendication 1, dans lequel le traitement thermique (d) est effectué avant l'application de la force explosive.

11. Procédé suivant la revendication 1, dans lequel le traitement thermique est effectué après l'application de la force explosive.

12. Procédé suivant la revendication 2, dans lequel la poudre de départ est composée de la poudre (3).

13. Procédé suivant la revendication 12, dans lequel l'oxyde (1-1) d'éléments des terres rares renfermant de l'yttrium est l'oxyde d'yttrium.

14. Procédé suivant la revendication 13, dans lequel l'oxyde de métal alcalino-terreux (1-2) est l'oxyde de baryum.

15. Procédé suivant la revendication 2, dans lequel la poudre de départ est composée de la poudre (3) et de poudre de l'agent apportant de l'oxygène.

16. Procédé suivant la revendication 15, dans lequel l'oxyde (1-1) d'éléments des terres rares renfermant de l'yttrium est l'oxyde d'yttrium.

17. Procédé suivant la revendication 16, dans lequel l'oxyde de métal alcalino-terreux (1-2) est l'oxyde de baryum.

18. Procédé suivant la revendication 1, qui consiste en outre à prévoir une couche d'oxyde sur la surface intérieure de l'enveloppe métallique.

19. Procédé suivant la revendication 1, dans lequel le traitement thermique (f) est conduit à une température de 300 à 950°C.

20. Procédé suivant la revendication 19, dans lequel le traitement thermique (f) est effectué à une température de 850 à 950°C.

21. Procédé suivant la revendication 20, dans lequel le traitement thermique (f) est effectué à une température de 900 à 940°C.

22. Procédé suivant la revendication 1, dans lequel l'enveloppe métallique est réalisée en un métal choisi dans le groupe comprenant le cuivre, l'argent et l'aluminium, et leurs alliages.

23. Procédé suivant la revendication 22, dans lequel l'enveloppe métallique est réalisée en argent ou en un alliage d'argent.

24. Procédé suivant la revendication 1, dans lequel l'agent apportant de l'oxygène est $Ag_2O$, $MnO_2$, $MoO_3$, $WO_3$, $V_2O_5$ ou $Ti_3O_5$.

25. Procédé suivant la revendication 24, dans lequel l'agent apportant de l'oxygène est $Ag_2O$.

**Patentansprüche**

1. Verfahren zur Verarbeitung eines superleitenden Keramikmaterials, das im wesentlichen aus einem Yttrium einschließenden Seltenerdelement, einem Erdalkalimetall, Kupfer und Rest Sauerstoff und unvermeidliche Verunreinigungen zusammengesetzt ist und das gegebenenfalls ein Metall enthält, das von einem Sauerstoff liefernden Mittel stammt, das umfaßt:

   (a) Bereitstellen eines Ausgangspulvers, das zusammengesetzt ist aus:

   (i) einem Glied, das aus der Gruppe ausgewählt ist, die besteht aus:

   (1) einem Mischpulver, das aus Pulvern zusammengesetzt ist aus:

   (1-1) einem Yttrium einschließenden Seltenerdelementoxid,

   (1-2) einem Erdalkalimetalloxid, und

   (1-3) Kupferoxid,

   wobei die Mischung eine Zusammensetzung aufweist, die im wesentlichen die gleiche ist wie die der beabsichtigten superleitenden Keramik,

   (2) einem Mischpulver, das aus Pulvern zusammengesetzt ist aus

   (2-1) einer Teilverbindung zwischen irgendwelchen zwei der Oxidkomponenten, die eine beabsichtigte superleitende Keramik bilden und ausgewählt sind aus (1-1), (1-2) und (1-3), und

   (2-2) dem Rest der Oxidkomponente, der ausgewählt ist aus (1-1), (1-2) und (1-3),

   wobei die Mischung eine Zusammensetzung aufweist, die im wesentlichen die gleiche ist wie die der beabsichtigten superleitenden Keramik,

   (3) einem Pulver einer superleitenden Keramik, die im wesentlichen aus einem Yttrium einschließenden Seltenerdelement, einem Erdalkalimetall, Kupfer und Rest Sauerstoff und unvermeidbare Verunreinigungen zusammengesetzt ist,

   (4) einem Mischpulver, das aus wenigstens zwei Gliedern zusammengesetzt ist, die aus den Mischpulvern (1), (2) und (3) ausgewählt sind; und

   (ii) gegebenenfalls einem Sauerstoff liefernden Mittel;

   (b) Anordnen des genannten Ausgangspulvers in einer Metallumhüllung und Verschließen der genannten Metallumhüllung;

   (c) Einwirkung einer Explosionskraft auf das genannte Ausgangspulver von außerhalb der Metallum-

EP 0 296 639 B1

hüllung, um das genannte Ausgangspulver in schock-verdichteten Zustand zu überführen;
(d) gegebenenfalls Wärmebehandeln des genannten Ausgangspulvers, wenn das genannte Ausgangspulver das Mischpulver (1), (2) oder (4) ist, bei einer Temperatur, die ausreicht, das genannte Ausgangspulver zu calcinieren, und zwar vor oder nach der Einwirkung des Explosionskraft;
(e) Verarbeiten des genannten explosionsverdichteten Produkts um einen Gegenstand einer vorgegebenen Form herzustellen; und
(f) gegebenenfalls Wärmebehandeln des genannten Gegenstands bei einer Temperatur von 300°C bis 950°C.

2. Verfahren nach Anspruch 1, bei dem das Ausgangspulver das Mischpulver (1) und/oder (2) und/oder (4) ist.

3. Verfahren nach Anspruch 2, bei dem das genannte Ausgangspulver aus dem Mischpulver (1) zusammengesetzt ist.

4. Verfahren nach Anspruch 3, bei dem das genannte Yttrium einschließende Seltenerdelementoxid (1-1) Yttriumoxid ist.

5. Verfahren nach Anspruch 4, bei dem das genannte Erdalkalimetalloxid (1-2) Bariumoxid ist.

6. Verfahren nach Anspruch 2, bei dem das genannte Ausgangspulver aus dem Mischpulver (1) und/oder (2) und/oder (4) und dem Sauerstoff liefernden Mittel zusammengesetzt ist.

7. Verfahren nach Anspruch 6, bei dem das genannte Ausgangspulver aus (1) und dem Sauerstoff liefernden Mittel zusammengesetzt ist.

8. Verfahren nach Anspruch 7, bei dem das genannte Yttrium einschließende Seltenerdelementoxid Yttriumoxid ist.

9. Verfahren nach Anspruch 8, bei dem das genannte Erdalkalimetalloxid (1-2) Bariumoxid ist.

10. Verfahren nach Anspruch 1, bei dem die genannte Wärmebehandlung (d) von der Anwendung der genannten Explosionskraft durchgeführt wird.

11. Verfahren nach Anspruch 1, bei dem die genannte Wärmebehandlung nach der Anwendung der Explosionskraft durchgeführt wird.

12. Verfahren nach Anspruch 2, bei dem das genannte Ausgangspulver aus dem Pulver (3) zusammengesetzt ist.

13. Verfahren nach Anspruch 12, bei dem das genannte Yttrium einschließende Seltenerdelementoxid (1-1) Yttriumoxid ist.

14. Verfahren nach Anspruch 13, bei dem das genannte Erdalkalimetalloxid (1-2) Bariumoxid ist.

15. Verfahren nach Anspruch 2, bei dem das genannte Ausgangspulver aus dem Pulver (3) und dem Pulver des Sauerstoff liefernden Mittels zusammengesetzt ist.

16. Verfahren nach Anspruch 15, bei dem das genannte Yttrium einschließende Seltenerdelementoxid (1-1) Yttriumoxid ist.

17. Verfahren nach Anspruch 16, bei dem das genannte Erdalkalimetalloxid (1-2) Bariumoxid ist.

18. Verfahren nach Anspruch 1, das außerdem die Schaffung einer Oxidschicht auf der Innenoberfläche der genannten Metallumhüllung umfaßt.

19. Verfahren nach Anspruch 1, bei dem die genannte Wärmebehandlung (f) bei einer Temperatur von 300 bis 950°C durchgeführt wird.

45

20. Verfahren nach Anspruch 19, bei dem die genannte Wärmebehandlung (e) bei einer Temperatur von 850°C bis 950°C durchgeführt wird.

21. Verfahren nach Anspruch 20, bei dem die genannte Wärmebehandlung (f) bei einer Temperatur von 900 bis 940°C durchgeführt wird.

22. Verfahren nach Anspruch 1, bei dem die genannte Metallumhüllung aus einem Metall hergestellt ist, das aus der Gruppe ausgewählt ist, die aus Kupfer, Silber und Aluminium und Legierungen davon besteht.

23. Verfahren nach Anspruch 22, bei dem die genannte Metallumhüllung aus Silber und einer Legierung davon hergestellt ist.

24. Verfahren nach Anspruch 1, bei dem das genannte Sauerstoff liefernde Mittel $Ag_2O$, $MnO_2$, $MoO_3$, $WO_3$, $V_2O_5$ oder $Ti_3O_5$ ist.

25. Verfahren nach Anspruch 24, bei dem das genannte Sauerstoff liefernde Mittel $Ag_2O$ ist.